# EUROPEAN PATENT APPLICATION

(11) **EP 1 628 327 A2**
(43) Date of publication of application: **22.02.2006**
(21) Application number: 05015141.4
(22) Date of filing: 12.07.2005
(51) Int. Cl.: H01L 21/02, H01L 21/8246, H01L 27/115

(54) **Dielectric memory device and method for fabricating the same**

(30) Priority: 20.08.2004 JP 2004240486; 29.10.2004 JP 2004315766
(71) Applicant: MATSUSHITA ELECTRIC INDUSTRIAL CO., LTD., Kadoma-shi, Osaka 571-8501 (JP)
(72) Inventor: Mikawa, Takumi, Otsu-shi Shiga 520-2101 (JP); Okuni, Mitsuhiro, Nara-shi Nara 631-0806 (JP); Yoshida, Hiroshi, Takatsuki-shi Osaka 569-1143 (JP)
(74) Representative: Grünecker, Kinkeldey, Stockmair & Schwanhäusser Anwaltssozietät

(57) **Abstract**

A method for fabricating a dielectric memory device is carried out in the following manner. A first lower electrode is formed above a substrate, and then a first insulating film is formed on the first lower electrode. Through the first insulating film, a hole is formed which reaches an upper surface of the first lower electrode, and then a conductive film is formed on at least the sides and bottom of the hole. Etching is performed to remove a portion of the conductive film located on the bottom of the hole, thereby forming a second lower electrode made of the conductive film remaining on the sides of the hole. On the first and second lower electrodes, a capacitor insulating film is formed so that the hole is not fully filled with the film; and then an upper electrode is formed on the capacitor insulating film.

## Description

### CROSS-REFERENCE TO RELATED APPLICATIONS

This application claims priority under 35 U.S.C. § 119 on Patent Application No. 2004-240486 filed in Japan on August 20, 2004, Patent Application No. 2004-315766 filed in Japan on October 29, 2004, and Patent Application No. 2005-107900 filed in Japan on April 4, 2005, the entire contents of which are hereby incorporated by reference.

### BACKGROUND OF THE INVENTION

### (a) Fields of the Invention

The present invention relates to dielectric memory devices with three-dimensional capacitor structures, and to methods for fabricating such a device.

### (b) Description of Related Art

The trend in the field of ferroelectric memory devices is toward mass production of those of planar or stacked structures having a small capacity of 1 to 64 kbit. Recently, development has been advancing of ferroelectric memory devices having three-dimensionally stacked structures (3D stacked structures) in which, for example, a ferroelectric film is applied as a capacitor insulating film to cover the inner surface and shoulder of each capacitor opening so that it has a flat portion and a side wall portion. The ferroelectric memory devices with the 3D stacked structures are constructed so that a contact plug electrically connected to a semiconductor substrate is arranged immediately below a lower electrode, which reduces their cell sizes to improve their packing densities. In addition to this, since the ferroelectric memory devices with the 3D stacked structures have a capacitor insulating film formed on the inner surface and shoulder of each capacitor opening, this increases the surface area of the capacitor insulating film to secure a large capacitance of the device.

Ahead of these ferroelectric memory devices, a variety of DRAM cell structures have been proposed (see, for example, Patent Document 1: United States Patent Publication No. 6239461 (from line 44 of column 5 to line 26 of column 6 and FIG. 5), Patent Document 2: Japanese Unexamined Patent Publication No. S61-296722 (pp. 2 to 3 and FIG. 1), Patent Document 3: Japanese Unexamined Patent Publication No. H5-226583, Patent Document 4: Japanese Unexamined Patent Publication No. H9-148534, and Patent Document 5: Japanese Patent Publication No. 3415478 (pp. 4 to 6, and FIGS. 1 to 3)). In particular, the structure of a DRAM which has a stacked capacitor using a high dielectric film, such as a BST film, as a capacitor insulating film can be compared with the structure of a FeRAM which has a stacked capacitor using a ferroelectric film as a capacitor insulating film.

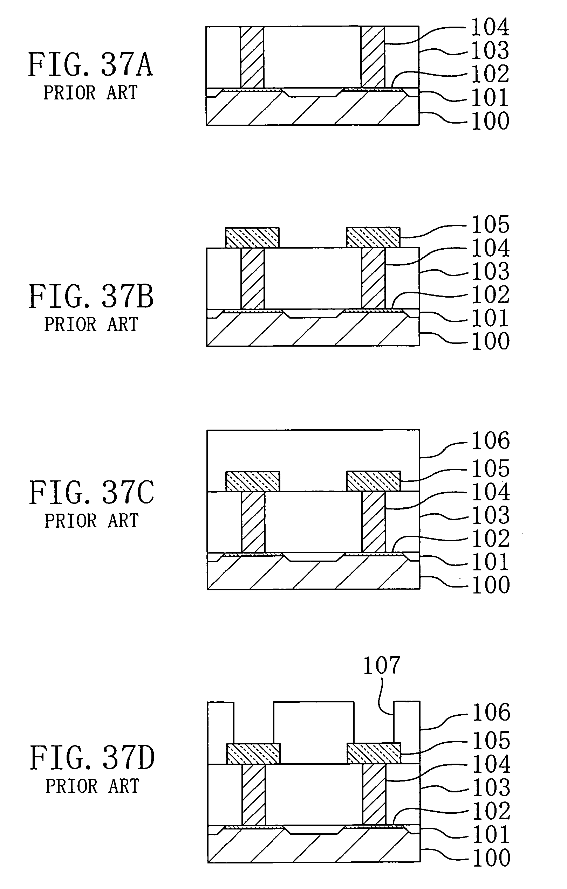

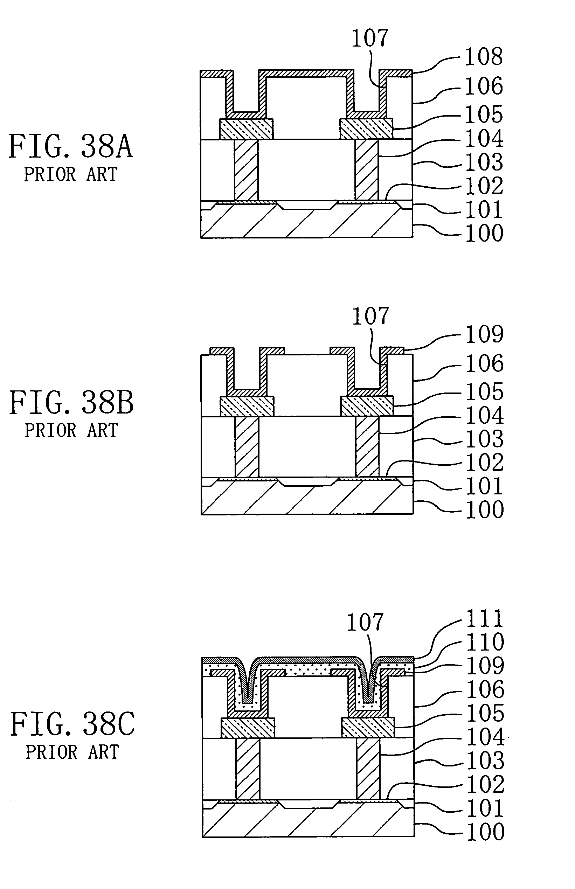

Hereinafter, a fabrication method of a dielectric memory device according to a first conventional example will be described with reference to FIGS. **37A** to **37D** and **38A** to **38C.** FIGS. **37A** to **37D** and **38A** to **38C** are sectional views showing main process steps of the fabrication method of a dielectric memory device according to the first conventional example.

First, as shown in FIG **37A,** an impurity diffusion layer **102** is formed in an element formation region defined by an isolation region (STI) **101** in a semiconductor substrate **100.** Subsequently, an interlayer insulating film **103** is formed on the isolation region **101** and the impurity diffusion layer **102.** A contact plug **104** for a storage node is formed which penetrates the interlayer insulating film 103 to connect the lower end thereof to the upper surface of the impurity diffusion layer **102.**

Next, as shown FIG **37B,** on the interlayer insulating film **103,** an oxygen barrier film 105 exhibiting conductivity is formed to cover the contact plug **104** to connect the lower surface thereof to the upper end of the contact plug **104.**

Thereafter, as shown in FIG. **37C,** an insulating film **106** is formed on the interlayer insulating film **103** to cover the oxygen barrier film **105,** and then the surface of the formed insulating film **106** is planarized by a CMP method.

As shown in FIG. **37D,** by dry etching, a capacitor opening **107** is formed through the insulating film **106.** The capacitor opening **107** is a hole which penetrates the insulating film **106** to expose the upper surface of the oxygen barrier film **105.**

Next, as shown in FIG. **38A,** a conductive film **108** (for example, precious metal typified by Pt or Ir, or its metal oxide) that will be formed into a lower electrode is formed on wall and bottom portions of the capacitor opening **107** and on top of the insulating film **106.**

Thereafter, as shown in FIG. **38B,** patterning with a desired mask is performed to form a lower electrode **109** on the wall and bottom portions of the capacitor opening **107** and on top of a portion of the insulating film **106** located around the opening edge of the capacitor opening **107.**

As shown in FIG. **38C,** by an MOCVD method, a capacitor insulating film **110** of a ferroelectric film is formed over the entire surface of the semiconductor substrate **100** to cover the lower electrode **109,** and then an upper electrode **111** is formed on the formed capacitor insulating film **110**.

In the manner described above, the dielectric memory device having the 3D-stacked capacitor structure can be fabricated (see, for example, Patent Document 1).

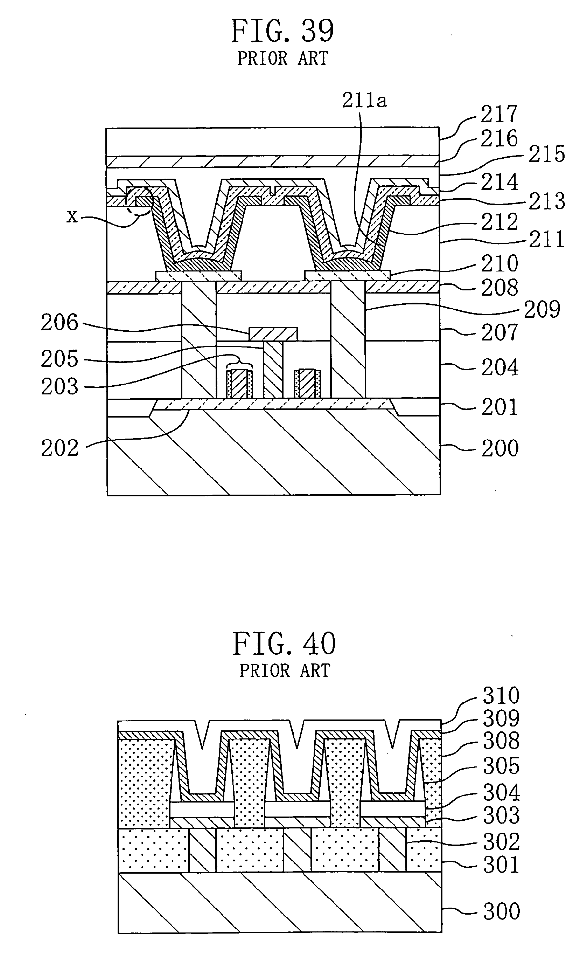

Hereinafter, a dielectric memory device with a 3D stacked structure according to a second conventional example will be described with reference to FIG. **39.** FIG. **39** is a sectional view showing main parts of the dielectric memory device with the 3D stacked structure according to the second conventional example.

Referring to FIG. **39,** an impurity diffusion layer **202** is formed in an element formation region defined by an isolation region (STI: shallow trench isolation) **201** in a semiconductor substrate **200.** A gate electrode **203** is formed on the element formation region of the semiconductor substrate **200.** Over the semiconductor substrate **200,** a first insulating film **204** is formed to cover the gate electrode **203,** and through the first insulating film **204,** a first contact plug **205** is formed which penetrates the first insulating film **204** to connect the lower end thereof to the impurity diffusion layer **202.** On the first insulating film **204,** a bit line **206** is formed to connect the lower surface thereof to the upper end of the first contact plug **205.** On the first insulating film **204,** a second insulating film **207** is formed to cover the bit line **206,** and a first hydrogen barrier film **208** is formed on the second insulating film **207.**

Through the first hydrogen barrier film **208,** the second insulating film **207,** and the first insulating film **204,** a second contact plug **209** is formed which penetrates these films to connect the lower end thereof to the impurity diffusion layer **202.** On the first hydrogen barrier film **208,** an oxygen barrier film **210** exhibiting conductivity is formed to connect the lower surface thereof to the upper end of the second contact plug **209.** On the first hydrogen barrier film **208** and the oxygen barrier film **210,** a third insulating film **211** is formed which has a recess **211a** therein.

A lower electrode **212** is formed on wall and bottom portions of the recess **211a** and on top of a portion of the third insulating film **211** located around the edge of the recess **211a.** A capacitor insulating film **213** of a ferroelectric film is formed on the lower electrode **212** and the third insulating film **211,** and an upper electrode **214** is formed on the capacitor insulating film **213.** On the upper electrode **214,** a fourth insulating film **215** is formed so that the recess **211a** is filled with the film. On the fourth insulating film **215,** a second hydrogen barrier film **216** and a fifth insulating film **217** are sequentially formed from bottom to top.

In the structure shown above, as shown in FIG. **39,** the recess **211a** has a tapered cross section in order to prevent the lower electrode **212,** the capacitor insulating film **213,** and the upper electrode **214** from being formed with poor step coverage, and its taper angle is about 70 to 80°. Furthermore, the edge of the lower electrode **212** extends outside the opening of the recess **211a** and is disposed on top of the third insulating film **211.**

Hereinafter, a dielectric memory device with a 3D stacked structure according to a third conventional example will be described with reference to FIG. **40.** The dielectric memory device of the third conventional example uses Ru films as upper and lower electrodes, and a high dielectric film, such as a BST film, as a capacitor insulating film. FIG. **40** is a sectional view showing main parts of the dielectric memory device with the 3D stacked structure according to the third conventional example.

Referring to FIG. **40,** a first interlayer insulating film **301** is formed on a semiconductor substrate **300** made of a silicon substrate. Through the first interlayer insulating film **301,** a capacitor contact **302** of polysilicon is formed which penetrates the first interlayer insulating film **301** to connect the lower end thereof to a predetermined region (for example, a source/drain region) of the semiconductor substrate **300.** On the first interlayer insulating film **301,** a barrier metal layer **303** is formed to connect the lower surface thereof to the upper end of the capacitor contact **302.** On the barrier metal layer **303,** a first electrode layer **304** and a second electrode layer **305** of cylindrical or box shape are sequentially formed from bottom to top. As shown above, a lower electrode of cylindrical or box shape with a bottom is formed which is composed of the barrier metal layer **303,** the first electrode layer **304,** and the second electrode layer **305** and which has a recess in the center thereof. The side wall of the second electrode layer **305** with a cylindrical or box shape extending upward from the bottom of the recess is characterized in that when viewed in the sectional view shown in FIG. **40,** it has a triangular cross section with an acute vertex angle (see, for example, Patent Document 5).

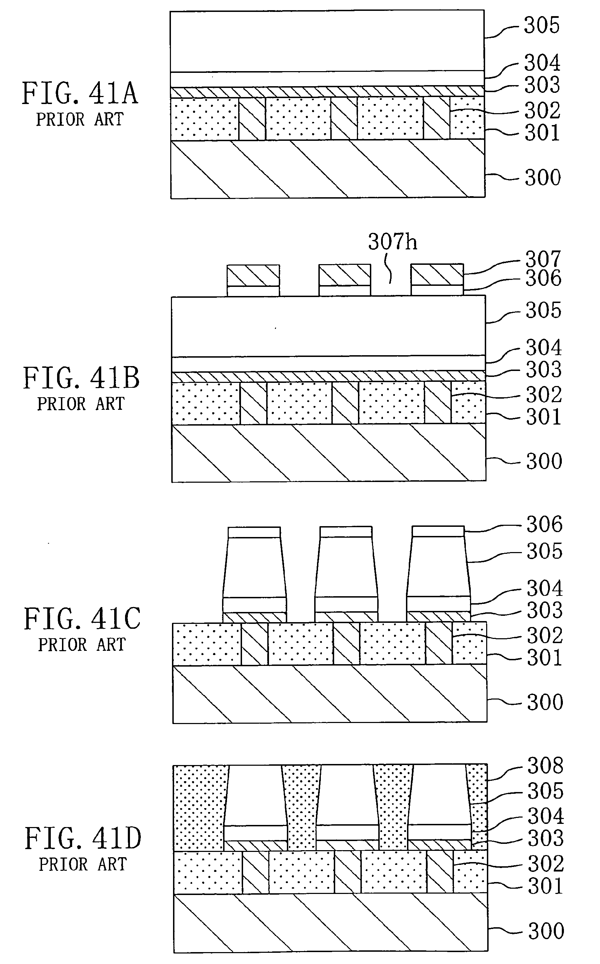

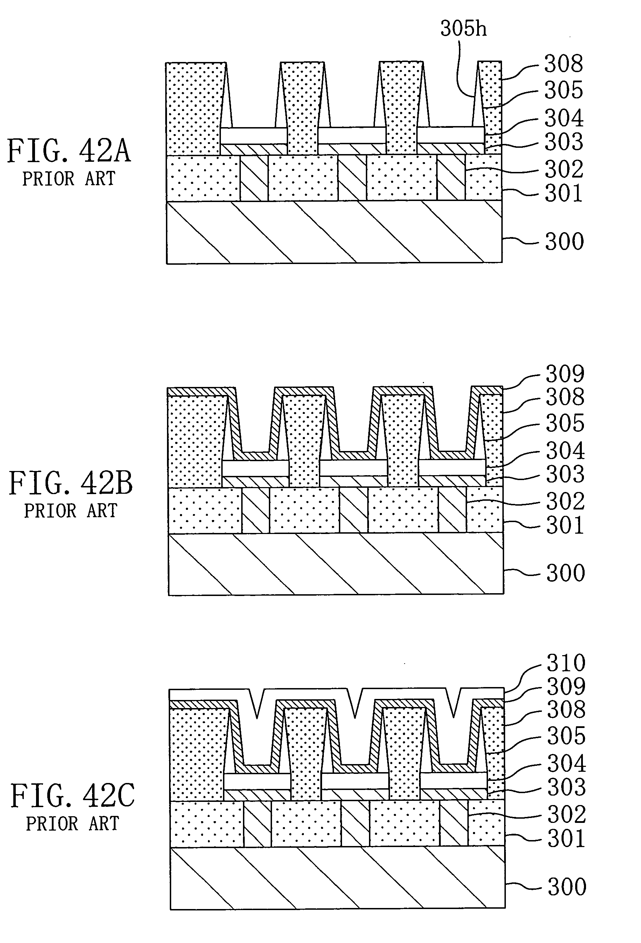

Next, a method for fabricating a dielectric memory device with a stacked structure according to the third conventional example will be described with reference to FIGS. **41A** to **41D** and **42A** to **42D.** Note that FIGS. **41A** to **41D** and **42A** to **42D** are sectional views showing main process steps of the method for fabricating a dielectric memory device with a stacked structure according to the third conventional example.

First, as shown in FIG. **41A,** the first interlayer insulating film **301** is formed on the semiconductor substrate **300** made of silicon, and then the capacitor contact **302** of polysilicon is formed which penetrates the first interlayer insulating film **301** to make connection to a predetermined region (for example, a source/drain region (not shown)) of the semiconductor substrate **300.** Subsequently, on the first interlayer insulating film **301,** the barrier metal layer **303** is formed by sequentially stacking, from bottom to top, a 50 nm-thick TiN layer and a 50 nm-thick Ti layer. The first electrode layer **304** made of an 80 nm-thick Ir film and the second electrode layer **305** made of a 400 nm-thick Ru film and having a cylindrical or box shape are sequentially formed on the barrier metal layer **303.**

Next, as shown in FIG. **41B,** a 400 nm-thick SiO₂ film is formed on the second electrode layer **305.** A photoresist film is formed on the formed SiO₂ film, and then photolithography is carried out to form a photoresist film **307** with an opening pattern **307h.** Using the photoresist film **307** with the opening pattern **307h** as a mask, the SiO₂ film is etched to form an etching mask **306** with the opening pattern **307h.**

After the photoresist film **307** is removed by an ashing process, as shown in FIG. **41C,** the second and first electrode layers **305** and **304** are etched using the etching mask **306.** By an RIE method using Cl₂ gas as an etching gas, the barrier metal layer **303** is etched also using the etching mask **306.** Thereby, under the etching mask **306,** an insular protrusion of substantially trapezoidal shape is formed which is composed of the second electrode layer **305,** the first electrode layer **304,** and the barrier metal layer **303,** and concurrently the surface of the first interlayer insulating film **301** is exposed.

As shown in FIG. **41D,** over the entire surface of the semiconductor substrate **300,** the second interlayer insulating film **308** made of a TEOS layer is formed so that the gap between the banded protrusions is filled with the film and then the film finally exceeds in height the upper surface of the protrusion. Thereafter, by a CMP technique, the etching mask **306** and part of the second interlayer insulating film **308** are polished for removal to expose the upper surface of the second electrode layer 305 and to planarize the surfaces of the second interlayer insulating film **308** and the second electrode layer **305.**

Then, as shown in FIG. **42A,** using the second interlayer insulating film **308** as a mask and the first electrode layer **304** as an etch stop layer, the second electrode layer **305** is etched to form a recess **305h** exposing the upper surface of the first electrode layer **304.** Thus, the lower electrode of cylindrical or box shape with a bottom is formed which is composed of the barrier metal layer **303,** the first electrode layer **304,** and the second electrode layer **305** and which has the recess **305h** in the center thereof. The second electrode layer **305** with a cylindrical or box shape extending upward from the bottom of the recess **305h** has a side wall of triangular shape with an acute vertex angle when viewed in the sectional view shown in FIG. **42A,** and the angle which the boundary surface between the second interlayer insulating film **308** and the second electrode layer 305 forms with the main surface of the semiconductor substrate **300** is 90° or greater.

Then, as shown in FIG. **42B,** on wall and bottom portions of the recess **305h** and the upper surface of the second interlayer insulating film **308,** a capacitor insulating film 309 is formed which is made of a 30 nm-thick BST film.

As shown in FIG. **42C,** on the capacitor insulating film **309,** an upper electrode **310** is formed which is made of a 500 nm-thick Ru film. In the manner described above, the dielectric memory device shown in FIG. **40** is fabricated.

### SUMMARY OF THE INVENTION

In the above-mentioned method for fabricating a dielectric memory device according to the first conventional example, the lower electrode **109** has to be formed in such a manner that after formation of the conductive film **108** on the insulating film **106** including the inside of the capacitor opening **107,** the conductive film **108** is patterned with the desired mask. In this case, in order to prevent the edge of the lower electrode **109** from falling within the capacitor opening **107,** it is necessary to allow a margin for mask alignment. Therefore, the edge of the lower electrode **109** is formed even on top of a portion of the insulating film **106** located around the mouth edge of the capacitor opening **107.** This causes the problem that the method for fabricating a dielectric memory device according to the first conventional example is not suited for miniaturization of a cell of the device.

Furthermore, this method also has the problem that it is difficult to form the lower electrode 109 within the capacitor opening **107** with good step coverage. In currently used techniques, for film formation of a precious metal-based material such as Pt or Ir, sputtering is the mainstream, but CVD or plating are still in the testing stage and are not in actual use yet. When the lower electrode **109** is formed within the capacitor opening **107** by a sputtering method, part of the lower electrode **109** formed on the bottom portion of the capacitor opening **107** has poor step coverage. As a result of this, heat treatment necessary for crystallization of ferroelectric that will be performed in a later step induces a break in the lower electrode **109.**

Moreover, depending on the diameter of the capacitor opening **107,** no sputtering particle may reach the inside of the capacitor opening **107.** In this case, even though a collimated sputtering technique or the like is used to increase vertical components of the magnetic field, it is conceivable that the particles will enter the inside of the capacitor opening **107** with a low degree of efficiency. If anything, the sputtering rate would decrease to require a greater amount of precious metal whose unit cost is very expensive. This causes the problem of a rise in manufacturing cost. From concern about the above problems, the actual action results in an approach in which the opening diameter of the capacitor opening **107** is adjusted in agreement with the performance of sputtering equipment used and the cell structure is constructed using the opening within a possible diameter range. As a consequence, if ensuring of an adequate electrode area is attempted, the cell size will inevitably increase.

In the dielectric memory device according to the second conventional example, in order to prevent creation of an overhung portion in forming the lower electrode **212** by a sputtering method or the like and resultant degradation in step coverage, the wall portion of the recess **211a** is formed to have a taper shape. This structure causes the problem that the opening diameter of the upper part of the recess **211a** becomes large to increase the cell size in a horizontal direction along the main surface of the semiconductor substrate **200** by an amount corresponding to the taper angle.

Moreover, for the same reason as the first conventional example mentioned above, the second conventional example has the problem of an increase in cell size. Furthermore, this example has the problem that an electric field is concentrated on a corner x of an edge of the lower electrode **211** to degrade the reliability characteristics (such as endurance capability) of the ferroelectric film as the capacitor insulating film **213.**

In the dielectric memory device according to the third conventional example, no lower electrode is formed on top of the second interlayer insulating film **308.** Therefore, as understood from the fabrication method described previously, the dielectric memory device according to the third conventional example is fabricated utilizing an advantage that in the second electrode layer **305** made of a Ru film of precious metal difficult to etch, the wall portion thereof is tapered by etching. In addition, utilizing the insular protrusion of taper shape formed by etching the second electrode layer **305,** etching is performed using the second interlayer insulating film 308 surrounding the insular protrusion as a mask to form, as shown in FIG. **42A,** the recess **305h** in a self-aligned manner. Thus, the second electrode layer 305 is formed which has a triangular cross section with an acute vertex angle.

However, with the method for fabricating a dielectric memory device according to the third conventional example, the second electrode layer **305** made of a conductive film more difficult to etch than an insulating film has to be etched at least twice. The two-time etching forms the recess **305h** having a taper shape inside and outside the wall portion. Thus, in etching the second electrode layer **305,** it is necessary to allow a margin as a distance between adjacent recesses **305h** by an amount corresponding to the taper shapes inside and outside the wall portion. This causes the problem that miniaturization of the cell size in a horizontal direction along the main surface of the semiconductor substrate 300 is difficult.

Moreover, the process required to form the lower electrode is complicated. In addition to this, the period of time a material for an electrode difficult to etch is etched increases, and the amount of this material to be etched becomes great. This causes the problem that the productivity of the device is lowered.

With the foregoing in mind, an object of the present invention is to provide a dielectric memory device which can improve the step coverage of a capacitor insulating film and miniaturize its cell size, and to provide a method for fabricating such a device.

To accomplish this object, a first method for fabricating a dielectric memory device according to one aspect of the present invention is characterized by including the steps of: forming a first lower electrode above a substrate; forming a first insulating film on the first lower electrode; forming a hole through the first insulating film down to an upper surface of the first lower electrode; forming a conductive film on at least the sides and bottom of the hole; performing etching to remove a portion of the conductive film located on the bottom of the hole, thereby forming a second lower electrode made of the conductive film remaining on the sides of the hole; forming a capacitor insulating film on the first and second lower electrodes so that the hole is not fully filled with the film; and forming an upper electrode on the capacitor insulating film.

With the first method for fabricating a dielectric memory device according to one aspect of the present invention, etching is performed to remove a portion of the conductive film located on the bottom of the hole, whereby the second lower electrode of smooth shape (referred hereinafter to as sidewall shape) can be formed on the sides of the hole in a self-aligned manner. Thus, this method does not have the step of patterning the conductive film using a mask, so that the number of times masks are used can be reduced. Consequently, the yield of the device can be improved. Moreover, the second lower electrode can be formed only on the sides of the hole in a self-aligned manner. This eliminates the necessity to allow a margin for mask alignment (alignment margin) with respect to the hole, which would conventionally be required in forming the lower electrode within the hole. Therefore, the distance between holes (that is, between capacitors) can be decreased, so that miniaturization of the cell can be attained. Furthermore, since the second lower electrode does not remain on top of the first insulating film, a local concentration of an electric field can be released.

Moreover, even when the conductive film is deposited by a sputtering method or the like, etching of the conductive film can suppress overhang occurring during the deposition. Therefore, the occurrence of a break of a conducting line due to the overhang can be prevented. Furthermore, since the second lower electrode formed within the hole by etching has a sidewall shape, the capacitor insulating film with good step coverage can be formed on the second lower electrode having a smoother inclined surface than the sides of the hole. As is apparent from the above, with the first method for fabricating a dielectric memory device according to one aspect of the present invention, a three-dimensional capacitor with excellent step coverage can be formed without changing the opening diameter of the upper portion of the hole, and concurrently miniaturization of the cell can be attained.

Preferably, the first method for fabricating a dielectric memory device according to one aspect of the present invention further includes, after the step of forming a first insulating film and before the step of forming a hole, the step of forming, on the first insulating film, a second insulating film functioning as an etching stopper, and the step of forming a hole is the step of forming a hole through the first and second insulating films down to an upper surface of the first lower electrode.

With this method, the second insulating film difficult to etch is formed around the upper portion of the hole. This prevents part of the second insulating film located around the upper portion of the hole from being over-etched during the etching for removing a portion of the conductive film located on the bottom of the hole. Therefore, variations in hole height resulting from the over-etching can be suppressed, so that variations in cell capacitance accompanying the height variations can also be prevented.

Preferably, the first method for fabricating a dielectric memory device according to one aspect of the present invention further includes, after the step of forming a second lower electrode and before the step of forming a capacitor insulating film, the step of removing a portion of the first insulating film located above an upper edge of the second lower electrode.

With this method, since in the first insulating film forming the hole, a portion thereof which does not contribute to the capacitance can be removed, an efficient, economical capacitor can be fabricated. Moreover, since any level difference resulting from the presence and absence of the second lower electrode is not created around the upper part of the sides of the hole, the capacitor insulating film with good step coverage can be formed in a later step.

Preferably, in the first method for fabricating a dielectric memory device according to one aspect of the present invention, the step of forming a conductive film is carried out using a sputtering method.

At present, if a precious metal-based conductive film is used for a lower electrode, the film is generally made by a sputtering method. However, the sputtering method is inferior in step coverage to an MOCVD method, which causes the problem that the lower electrode formed by the sputtering method has an overhung portion therein. However, with the present invention, a portion of the conductive film located on the bottom of the hole can be removed by etching to form the second lower electrode only on the sides of the hole. Therefore, the problem of overhanging by the sputtering method can be avoided.

Preferably, in the first method for fabricating a dielectric memory device according to one aspect of the present invention, the first and second lower electrodes are made of the same conductive material.

With this method, the flexibility of another process can be enhanced.

Preferably, in the first method for fabricating a dielectric memory device according to one aspect of the present invention, the first and second lower electrodes are made of different conductive materials.

With this method, an etching condition having selectivity to the first lower electrode can be selected in forming the second lower electrode by etching. This reduces variations in cell capacitance resulting from over-etching, and provides availability for various cell designs.

A second method for fabricating a dielectric memory device according to one aspect of the present invention is characterized by including the steps of: forming a first lower electrode above a substrate; forming a first insulating film on the first lower electrode; forming a hole through the first insulating film down to an upper surface of the first lower electrode; performing etching to remove a portion of the first lower electrode exposed at the bottom of the hole, thereby forming a recess in the first lower electrode and a second lower electrode on the sides of the hole, the second lower electrode being made of a material having formed the portion of the first lower electrode removed during formation of the recess; forming a capacitor insulating film on the sides and bottom of the recess and on the second lower electrode so that the hole is not fully filled with the film; and forming an upper electrode on the capacitor insulating film.

With the second method for fabricating a dielectric memory device according to one aspect of the present invention, the second lower electrode of sidewall shape made of a material for part of the first lower electrode removed by etching in forming the recess in the first lower electrode can be formed within a capacitor opening composed of the hole and the recess in a self-aligned manner. Therefore, the second lower electrode can be efficiently formed within the capacitor opening of a desired size in a self-aligned manner. This eliminates the necessity to allow a margin for mask alignment (alignment margin) with respect to the hole, which would conventionally be required in forming the lower electrode within the hole. Therefore, the distance between holes (that is, between capacitors) can be decreased, so that miniaturization of the cell can be attained. Moreover, since no mask is required in processing the second lower electrode, the number of masks used can be reduced. Therefore, reduction of a mask removal step or the like can improve the yield of the device. Furthermore, since the capacitor opening is composed of the hole and the recess, it has a larger surface area than the capacitor opening composed of the hole only. Therefore, a sufficient capacitance can be secured and the step coverage of the lower part of the capacitor opening can be maintained. Moreover, since the second lower electrode does not remain on top of the first insulating film, a local concentration of an electric field can be released.

Preferably, the second method for fabricating a dielectric memory device according to one aspect of the present invention further includes, after the step of forming a hole and before the step of forming a recess and a second lower electrode, the step of forming a conductive film on the sides and bottom of the hole, and the step of forming a recess and a second lower electrode is the step of performing etching to remove portions of the first lower electrode and the conductive film formed on the bottom of the hole, thereby forming a recess in the first lower electrode and a second lower electrode on the sides of the hole, the second lower electrode being made of materials having formed the portions of the first lower electrode and the conductive film removed during formation of the recess.

With this method, the second lower electrode made of materials for portions of the first lower electrode and the conductive film removed by etching in forming the recess in the first lower electrode can be formed within a capacitor opening composed of the hole and the recess in a self-aligned manner. Therefore, not only the second lower electrode can be efficiently formed within the capacitor opening of a desired size in a self-aligned manner, but also a sufficient thickness of the second lower electrode on the side wall of the opening can be secured. Consequently, process stability can be enhanced. Moreover, if the conductive film is formed on top of a portion of the first insulating film located around the hole, the conductive film prevents thickness reduction of the first insulating film during etching. Therefore, the capacitor opening of a desired depth can be maintained, so that a decrease in cell capacitance can be suppressed.

Preferably, the second method for fabricating a dielectric memory device according to one aspect of the present invention further includes, after the step of forming a first insulating film and before the step of forming a hole, the step of forming, on the first insulating film, a second insulating film functioning as an etching stopper, and the step of forming a hole is the step of forming a hole through the first and second insulating films down to an upper surface of the first lower electrode.

With this method, by arranging, on the first insulating film, the second insulating film made of a material difficult to etch during the etching for recess formation, thickness reduction of the first insulating film contributing to a decrease in cell capacitance can be suppressed.

Preferably, in the second method for fabricating a dielectric memory device according to one aspect of the present invention, the first lower electrode is formed on a conductive layer formed above the substrate, and the etching is performed to remove a portion of the first lower electrode located on the bottom of the hole until the upper surface of the conductive layer is exposed.

With this method, by arranging, below the first lower electrode, the conductive layer made of a material difficult to etch, etching on the first lower electrode can be stopped at the moment at which the upper surface of the conductive layer is exposed. Therefore, the recess formed in the first lower electrode can have a fixed depth, so that variations in cell capacitance can be suppressed.

Preferably, the first or second method for fabricating a dielectric memory device according to one aspect of the present invention further includes, after the step of forming a second lower electrode and before the step of forming a capacitor insulating film, the step of annealing the second lower electrode in an oxygen atmosphere.

With this method, the bonding power of the second lower electrode made of a conductive film can be strengthened which has been weakened once by the etching. Thereby, the second lower electrode can exert a sufficient function as an electrode, so that a capacitor with stable characteristics can be provided.

Preferably, in the first or second method for fabricating a dielectric memory device according to one aspect of the present invention, the step of forming a capacitor insulating film is carried out using an MOCVD method.

For formation of the dielectric film through an MOCVD method using multiple types of gases, it is very difficult to accomplish both improvement of step coverage and maintenance of good polarization characteristics. However, with the first or second method, by forming the second lower electrode of sidewall shape, the opening of the hole expands upward, and thus gas easily enters the inside of the opening. Therefore, the difficulty in forming a film with good step coverage by an MOCVD method can be relieved.

Preferably, in the second method for fabricating a dielectric memory device according to one aspect of the present invention, the first and second lower electrodes are made of precious metal or an oxide of precious metal.

Since precious metal and an oxide of precious metal are chemically-stable, they have the property of resisting etching. Therefore, in etching these materials, depending on the etching condition, these materials do not volatilize by chemical reaction but are physically emitted by hitting. From this point, in the second method, these materials are suited for formation of the second lower electrode. In addition, during crystallization of a ferroelectric film at high temperatures, these materials do not react with the ferroelectric film. Also from this point, these materials are suited for the electrodes.

A first dielectric memory device according to one aspect of the present invention is characterized by including: a first lower electrode formed above a substrate; a first insulating film formed on the first lower electrode and having a hole reaching an upper surface of the first lower electrode; a second lower electrode formed on the sides of the hole; a capacitor insulating film formed on the first and second lower electrodes so that the hole is not fully filled with the film; and an upper electrode formed on the capacitor insulating film. This device is also characterized in that in the second lower electrode on the sides of the hole, a lower portion thereof on the lower part of the hole sides has a greater thickness than an upper portion thereof on the upper part of the hole sides.

With the first dielectric memory device according to one aspect of the present invention, the lower electrode is formed only on the sides of the hole, and not formed on top of the first insulating film. Therefore, miniaturization of the memory cell can be attained. Moreover, since the lower electrode does not remain on top of the first insulating film, a local concentration of an electric field can be released. Furthermore, since the second lower electrode of sidewall shape is formed on the sides of the hole, a smooth electrode shape can be formed and a local concentration of an electric field on the vicinity of the opening of the hole can be released to prolong the reliability characteristics of the dielectric film. In addition, in the case where the capacitor insulating film is formed by an MOCVD method, the step coverage of the formed film can be improved to release a local concentration of an electric field. Moreover, the hole has an opening diameter increasing upward and decreasing downward of the hole. Thereby, when the capacitor insulating film is formed by an MOCVD method, material gas enters easily within the opening of the hole. As a result, the capacitor insulating film with good step coverage can be formed on the second lower electrode provided on the sides of the hole.

A second dielectric memory device according to one aspect of the present invention is characterized by including: a first lower electrode formed above a substrate and having a recess in an upper portion thereof; a first insulating film formed on the first lower electrode and having a hole reaching the recess; a second lower electrode formed on the sides of the hole and having sidewalls continuous with the sides of the recess; a capacitor insulating film formed on the sides and bottom of the recess and on the second lower electrode so that the hole is not fully filled with the film; and an upper electrode formed on the capacitor insulating film. This device is also characterized in that in the second lower electrode on the sides of the hole, a lower portion thereof on the lower part of the hole sides has a greater thickness than an upper portion thereof on the upper part of the hole sides.

With the second dielectric memory device according to one aspect of the present invention, miniaturization of the memory cell can be attained like the first dielectric memory device. In addition to this, since the capacitor opening is composed of the hole and the recess, it has a larger surface area than the capacitor opening composed of the hole only. Therefore, a sufficient capacitance can be secured. Moreover, since the capacitor opening is composed of the hole and the recess and the second lower electrode is made of a material removed from the first lower electrode, the problem of a decrease in step coverage can be basically avoided which arises when the capacitor opening is formed deep in order to obtain a high capacitance. Therefore, the step coverage of a film at the lower portion of the capacitor opening can be maintained.

Preferably, the first or second dielectric memory device according to one aspect of the present invention further includes, on top of the first insulating film, a second insulating film functioning as an etching stopper.

With this device, the second insulating film difficult to etch is formed around the upper portion of the hole. This prevents part of the second insulating film located around the upper portion of the hole from being over-etched during the etching for forming the second lower electrode, which constructs the structure in which variations in hole height resulting from the over-etching are suppressed. Therefore, a dielectric memory device having decreased variations in cell capacitance can be obtained.

Preferably, in the first or second dielectric memory device according to one aspect of the present invention, the first and second lower electrodes are made of the same conductive material.

With this device, it is sufficient to consider the matching of the capacitor insulating film with an electrode material of one type, for example, the lattice matching during crystal growth, impurity diffusion from the electrode, or the like, so that the interaction between electrodes made of different materials does not have to be considered. Therefore, as compared with the case where the electrodes made of different materials are employed, the flexibilities of other processes are not restricted. Moreover, since the first and second lower electrodes are made of the same material, in the removal of the portion of the conductive film located on the bottom of the hole in the step of forming a second lower electrode, the first lower electrode located therebelow is over-etched to form the recess in the upper portion of the first lower electrode. Therefore, the area of the first lower electrode can be increased by an amount corresponding to the depth of the recess. This provides an increased effective capacitance of the inside of the cell opening.

Preferably, in the first or second dielectric memory device according to one aspect of the present invention, the first and second lower electrodes are made of different conductive materials.

For example, a material capable of sufficiently performing the function as an oxygen barrier film or a film for preventing impurity diffusion is employed for the first lower electrode, whereby the first lower electrode can be allowed to function as a layer for protecting a storage node contact plug. Moreover, since the first and second lower electrodes are made of materials of different types, the condition of etching for forming the second lower electrode can be set at the condition having selectivity to the first lower electrode. Therefore, as compared with the case where the same material is employed for the first and second lower electrodes, the over-etched amount of the first lower electrode can be reduced to prevent variations in effective capacitance of the inside of the cell opening.

Preferably, in the first or second dielectric memory device according to one aspect of the present invention, the first and second lower electrodes are made of precious metal or an oxide of precious metal.

In general, since precious metal and an oxide of precious metal are chemically-stable, the lower electrode made of precious metal or an oxide of precious metal does not react with a ferroelectric film during high-temperature annealing for crystallizing the ferroelectric film. Therefore, the lower electrode after the annealing can function as a lower electrode. Moreover, from the difference in characteristics, a FeRAM using a capacitor insulating film of a ferroelectric film includes an electrode and a capacitor insulating film which have much greater thicknesses than those of a DRAM. Therefore, in order for the FeRAM to obtain the same cell capacitance as the DRAM, its hole has to be formed to have a greater opening diameter than that of the DRAM in consideration of the difference in thickness. However, with the present invention, etching of the conductive film deposited within the hole reduces the thickness of the conductive film and forms the second lower electrode of sidewall shape, so that an increase in cell area can be decreased.

As described above, with the present invention, a conductive material located on the bottom of the hole can be etched to form, only within the sides of the hole, the lower electrode of a conductive material in a self-aligned manner. That is to say, a margin for mask alignment does not have to be allowed, so that the lower electrode can be efficiently formed within the capacitor opening of a desired size in a self-aligned manner. Thus, miniaturization of the cell can be attained and the dielectric memory device with excellent step coverage can be fabricated.

### BRIEF DESCRIPTION OF THE DRAWINGS

FIG. **1** is a sectional view showing main parts of the structure of a dielectric memory device according to a first embodiment of the present invention.
FIGS. **2A** to **2C** are sectional views showing main process steps of a method for fabricating a dielectric memory device according to the first embodiment of the present invention.
FIGS. **3A** to **3C** are sectional views showing main process steps of the method for fabricating a dielectric memory device according to the first embodiment of the present invention.
FIGS. **4A** to **4C** are sectional views showing main process steps of the method for fabricating a dielectric memory device according to the first embodiment of the present invention.
FIG. **5** is a sectional view showing main parts of the structure of a dielectric memory device according to a second embodiment of the present invention.
FIG. **6** is a sectional view showing main parts of an exemplary modification of the dielectric memory device according to the second embodiment of the present invention.
FIGS. **7A** to **7C** are sectional views showing main process steps of a method for fabricating a dielectric memory device according to the second embodiment of the present invention.
FIGS. **8A** to **8C** are sectional views showing main process steps of the method for fabricating a dielectric memory device according to the second embodiment of the present invention.
FIGS. **9A** to **9C** are sectional views showing main process steps of the method for fabricating a dielectric memory device according to the second embodiment of the present invention.
FIG. **10** is a graph showing the breakdown voltage capability of a capacitor in the case where a second lower electrode thereof is annealed in the second embodiment of the present invention.
FIG. **11** is a sectional view showing main parts of the structure of a dielectric memory device according to a third embodiment of the present invention.
FIGS. **12A** to **12C** are sectional views showing main process steps of a method for fabricating a dielectric memory device according to the third embodiment of the present invention.
FIGS. **13A** to **13C** are sectional views showing main process steps of the method for fabricating a dielectric memory device according to the third embodiment of the present invention.
FIGS. **14A** to **14C** are sectional views showing main process steps of the method for fabricating a dielectric memory device according to the third embodiment of the present invention.
FIGS. **15A** to **15C** are sectional views showing main process steps of an exemplary modification of the method for fabricating a dielectric memory device according to the second and third embodiments of the present invention.
FIGS. **16A** and **16B** are sectional views showing main process steps of the method for fabricating a dielectric memory device according to the second and third embodiments of the present invention, and showing how to form a second lower electrode from a conductive film deposited by a sputtering method.
FIG. **17** is a sectional view showing main parts of the structure of a dielectric memory device according to a fourth embodiment of the present invention.
FIG. **18** is a sectional view showing main parts of the structure of a dielectric memory device according to a fifth embodiment of the present invention.
FIG. **19** is a sectional view showing main parts of the structure of a dielectric memory device according to a sixth embodiment of the present invention.
FIGS. **20A** to **20C** are sectional views showing main process steps of a method for fabricating a dielectric memory device according to the sixth embodiment of the present invention.
FIGS. **21A** and **21B** are sectional views showing main process steps of the method for fabricating a dielectric memory device according to the sixth embodiment of the present invention.
FIGS. **22A** to **22C** are sectional views showing main process steps of the method for fabricating a dielectric memory device according to the sixth embodiment of the present invention.
FIG. **23** is a sectional view showing main parts of the structure of a dielectric memory device according to a seventh embodiment of the present invention.
FIGS. **24A** to **24C** are sectional views showing main process steps of a method for fabricating a dielectric memory device according to the seventh embodiment of the present invention.
FIGS. **25A** to **25C** are sectional views showing main process steps of the method for fabricating a dielectric memory device according to the seventh embodiment of the present invention.
FIGS. **26A** to **26C** are sectional views showing main process steps of the method for fabricating a dielectric memory device according to the seventh embodiment of the present invention.
FIGS. **27A** and **27B** are sectional views for concretely explaining formation of a second lower electrode in the method for fabricating a dielectric memory device according to the seventh embodiment of the present invention.
**FIG.** 28 is a graph showing the relation between a recess **42h** and the thickness of a side wall of a second lower electrode **44** in the seventh embodiment of the present invention.
FIG. **29** is a sectional view showing main parts of the structure of a dielectric memory device according to an eighth embodiment of the present invention.
FIGS. **30A** to **30C** are sectional views showing main process steps of a method for fabricating a dielectric memory device according to the eighth embodiment of the present invention.
FIGS. **31A** to **31C** are sectional views showing main process steps of the method for fabricating a dielectric memory device according to the eighth embodiment of the present invention.
FIGS. **32A** and **32B** are sectional views showing main process steps of the method for fabricating a dielectric memory device according to the eighth embodiment of the present invention.
FIG. **33** is a sectional view showing main parts of the structure of a dielectric memory device according to a ninth embodiment of the present invention.
FIGS. **34A** to **34C** are sectional views showing main process steps of a method for fabricating a dielectric memory device according to the ninth embodiment of the present invention.
FIGS. **35A** to **35C** are sectional views showing main process steps of the method for fabricating a dielectric memory device according to the ninth embodiment of the present invention.
FIGS. **36A** and **36B** are sectional views showing main process steps of the method for fabricating a dielectric memory device according to the ninth embodiment of the present invention.
FIGS. **37A** to **37D** are sectional views showing main process steps of a method for fabricating a dielectric memory device according to a first conventional example.
FIGS. **38A** to **38C** are sectional views showing main process steps of the method for fabricating a dielectric memory device according to the first conventional example.
FIG. **39** is a sectional view showing main parts of a dielectric memory device according to a second conventional example.
FIG. **40** is a sectional view showing main parts of a dielectric memory device according to a third conventional example.
FIGS. **41A** to **41D** are sectional views showing main process steps of a method for fabricating a dielectric memory device according to the third conventional example.
FIGS. **42A** to **42C** are sectional views showing main process steps of the method for fabricating a dielectric memory device according to the third conventional example.

### DETAILED DESCRIPTION OF THE PREFERRED EMBODIMENTS

Embodiments of the present invention will be described below with reference to the accompanying drawings.

### (First Embodiment)

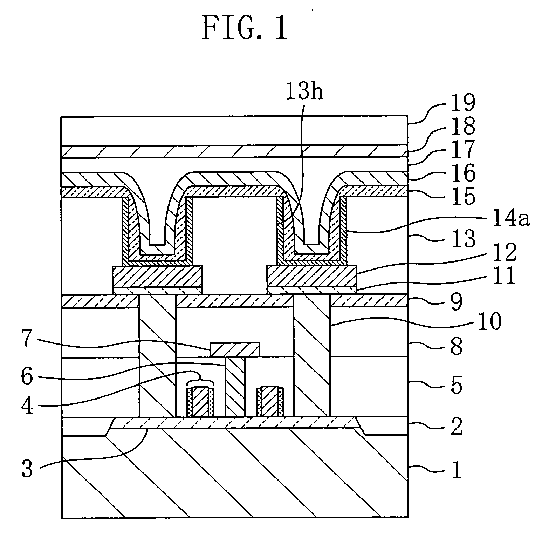

Hereinafter, a dielectric memory device according to a first embodiment of the present invention will be described with reference to FIG. **1.** FIG. **1** is a sectional view showing main parts of the structure of the dielectric memory device according to the first embodiment of the present invention.

Referring to FIG. **1,** an impurity diffusion layer **3** is formed in an element formation region defined by an isolation region (STI: shallow trench isolation) **2** in a semiconductor substrate **1.** A gate electrode **4** is formed on the element formation region of the semiconductor substrate **1.** Thus, the impurity diffusion layer **3** and the gate electrode **4** constitute a transistor. Over the entire surface of the semiconductor substrate **1,** a first insulating film **5** is formed to cover the transistor. Through the first insulating film **5,** a first contact plug **6** is formed which penetrates the first insulating film **5** to connect the lower end thereof to the impurity diffusion layer **3.** On the first insulating film **5,** a bit line **7** is formed to connect the lower surface thereof to the upper end of the first contact plug **6.** On the first insulating film **5,** a second insulating film **8** is formed to cover the bit line **7,** and a first hydrogen barrier film **9** is formed on the second insulating film **8.**

Through the first hydrogen barrier film **9,** the second insulating film **8,** and the first insulating film **5,** a second contact plug **10** is formed which penetrates these films to connect the lower end thereof to the impurity diffusion layer **3.** On the first hydrogen barrier film **9,** an oxygen barrier film **11** exhibiting conductivity is formed to connect the lower surface thereof to the upper end of the second contact plug **10,** and a first lower electrode **12** is formed on the oxygen barrier film **11.** On the first hydrogen barrier film **9,** a third insulating film **13** with an opening **13h** is formed to cover the oxygen barrier film **11** and the first lower electrode **12.** Note that the first contact plug **6** is a bit line contact and the second contact plug **10** is a storage node contact.

A second lower electrode **14a** is formed only on the sides and bottom of the opening **13h**. A capacitor insulating film **15** of a ferroelectric film is formed on the second lower electrode **14a** and the third insulating film **13,** and an upper electrode **16** is formed on the capacitor insulating film **15.** Thus, the first lower electrode **12,** the second lower electrode **14a,** the capacitor insulating film **15,** and the upper electrode **16** constitute a capacitor. On the upper electrode **16,** a fourth insulating film **17** is formed so that the opening **13h** is filled with the film. On the fourth insulating film **17,** a second hydrogen barrier film **18** and a fifth insulating film **19** are sequentially formed from bottom to top.

In the structure shown above, the oxygen barrier film **11** is, for example, a single-layer film of any one film selected from an Ir film, an IrO₂ film, a TiAIN film, and a TaAlN film, or a multilayer film of two or more films selected from the listed films. The first and second lower electrodes **12** and **14a** are made of, for example, precious metal such as Pt or Ir, or an oxide of this metal. The ferroelectric film forming the capacitor insulating film **15** is made of, for example, an SBT-, a PZT-, or a BLT-based material.

As described above, in the dielectric memory device according to the first embodiment of the present invention, the edge of the second lower electrode **14a** is formed not to extend on a portion of the third insulating film **13** located outside the upper part of the opening **13h** but to stay only within opening **13h.** This eliminates the necessity to allow an alignment margin used for patterning the lower electrode with respect to the opening, which would be required in the conventional fabrication method. Therefore, no alignment margin is required in the device, so that miniaturization of the capacitor cell in a horizontal direction along the main surface of the semiconductor substrate 1 can be attained.

Moreover, the sides of the opening **13h** are formed so that the angle between the sides of the opening and the main surface of the semiconductor substrate **1** is 90° or smaller, in other words, the opening **13h** whose sides are forward tapered is formed. Thereby, the opening **13h** has a shape whose opening diameter increases upward from the bottom thereof, so that the second lower electrode **14a,** the capacitor insulating film **15,** and the upper electrode **16** which will be formed later within the opening **13h** have improved step coverages. This provides a good film formation at a bending portion of the opening **13h,** so that the occurrence of a break or the like in a conductor line can be prevented.

In the first embodiment, description has been made of the structure of the device in which the second hydrogen barrier film **18** is formed between the fourth insulating film **17** covering the capacitor and the fifth insulating film **19.** If a ferroelectric material resistant to reduction is employed for the capacitor insulating film **15,** it is also acceptable that the first and second hydrogen barrier films **9** and **18** are not formed. However, in general, a combination of the hydrogen barrier films, for example, connection of the first and second hydrogen barrier films **9** and **18** at an edge of the memory cell enables a full covering of the capacitor with the hydrogen barrier films, and thereby deterioration in the characteristics of the ferroelectric capacitor by hydrogen can be prevented.

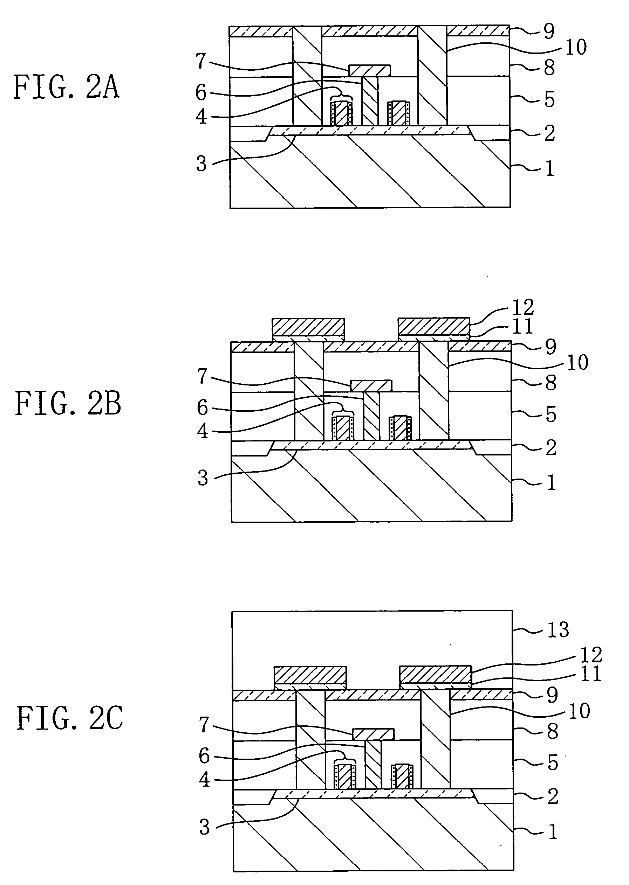

Hereinafter, a method for fabricating a dielectric memory device according to the first embodiment of the present invention will be described with reference to FIGS. **2A** to **2C, 3A** to **3C,** and **4A** to **4C.**

FIGS. **2A** to **2C, 3A** to **3C,** and **4A** to **4C** are sectional views showing main process steps of the method for fabricating a dielectric memory device according to the first embodiment of the present invention.

First, as shown in FIG. **2A,** the transistor composed of the impurity diffusion layer **3** and the gate electrode **4** is formed on a region of the semiconductor substrate **1** defined by the isolation region (STI) **2.** In this structure, over the entire surface of the semiconductor substrate **1,** the first insulating film **5** of, for example, a silicon dioxide (SiO₂) film with a thickness of about 500 to 800 nm is deposited to cover the transistor. Subsequently, through the first insulating film **5,** a first contact hole (not shown) is formed which penetrates the first insulating film **5** to reach the impurity diffusion layer **3,** and then the formed first contact hole is filled with tungsten (W) or polysilicon to form the first contact plug **6** serving as a bit line contact.

Next, a conductive film of W or TiN with a thickness of about 20 to 200 nm is deposited on the first insulating film **5** and the first contact plug **6,** and then the formed conductive film is etched using a desired mask to form the bit line **7** whose lower surface is connected to the upper end of the first contact plug **6.**

Subsequently, the second insulating film **8** of, for example, a silicon dioxide (SiO₂) film with a thickness of about 500 to 800 nm is deposited on the first insulating film 5, and then the first hydrogen barrier film **9** of, for example, a silicon nitride (SiN) film with a thickness of about 20 to 100 nm is deposited on the second insulating film **8.** Through the first hydrogen barrier film **9,** the second insulating film **8,** and the first insulating film **5,** a second contact hole (not shown) is formed which penetrates these films to reach the impurity diffusion layer **3.** The formed second contact hole is filled with tungsten (W) or polysilicon to form the second contact plug **10** serving as a storage node contact.

In the first embodiment, in the step shown in FIG. **2A,** the step of forming a cobalt silicide (CoSi₂) layer on the surface of the impurity diffusion layer **3** may be additionally provided. This step can reduce the resistance as compared with the case where no cobalt silicide layer is provided on the surface of the impurity diffusion layer **3,** which prevents delay in circuit operations. In addition, it is also acceptable that the first hydrogen barrier film **9** is not provided depending on the material for the capacitor insulating film to be formed later.

Subsequently to the formation of the second contact plug **10,** as shown in FIG. **2B,** the oxygen barrier film **11** having a thickness of about 20 to 200 nm and exhibiting conductivity is formed on the first hydrogen barrier film **9** and the second contact plug **10.** Note that in this formation, the lower surface of the oxygen barrier film **11** is connected to the upper end of the second contact plug **10.** In this structure, the oxygen barrier film **11** is, for example, a single-layer film of any one film selected from an Ir film, an IrO₂ film, a TiAIN film, and a TaAlN film, or a multilayer film of two or more films selected from the listed films. The oxygen barrier film **11** is provided to prevent oxidation of the second contact plug **10** during a thermal treatment in an oxygen atmosphere for crystallization of a ferroelectric film forming the capacitor insulating film **15** that will be described later. If the oxygen barrier film **11** is made of a TiAIN film, the oxygen barrier film **11** functions not only as an oxygen barrier film but also as a hydrogen barrier film. If the ferroelectric film forming the capacitor insulating film **15** that will be described later is crystallized at a sufficiently low temperature, the oxygen barrier film **11** does not have to be provided. Next, on the formed oxygen barrier film **11,** the first lower electrode **12** with a thickness of about 100 to 500 nm is formed which is made of, for example, precious metal such as Pt or Ir, or an oxide of this metal.

As shown in FIG. **2C,** over the entire surface of the first hydrogen barrier film **9,** the third insulating film **13** of, for example, SiO₂ with a thickness of about 500 to 1000 nm is deposited to cover the oxygen barrier film **11** and the first lower electrode **12,** and then the surface of the third insulating film **13** is planarized by a CMP method or the like.

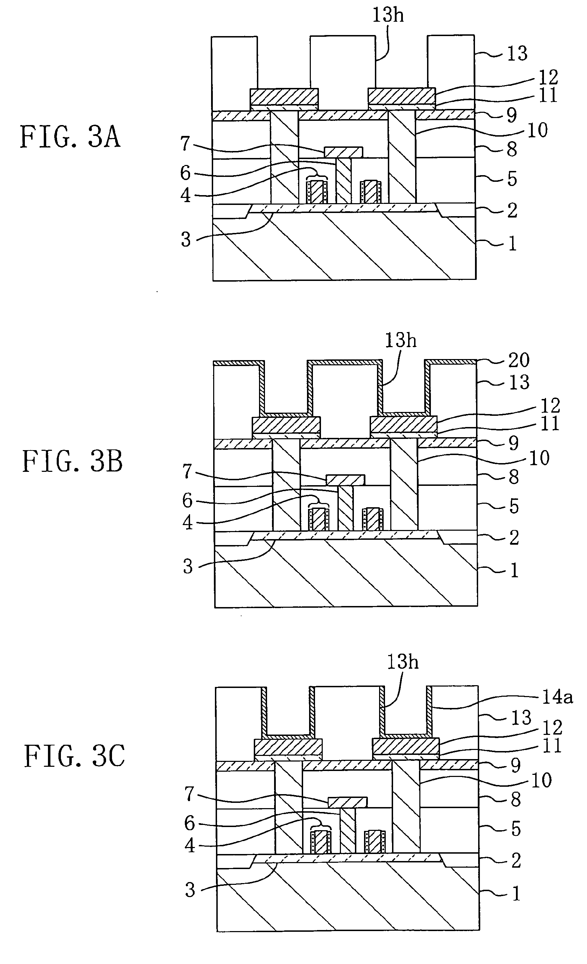

Subsequently, as shown in FIG. **3A,** by lithography and dry etching methods, the opening **13h** reaching the upper surface of the first lower electrode **12** is formed through the third insulating film **13.** The opening **13h** is formed so that the angle between each side of the opening **13h** and the main surface of the semiconductor substrate **1** is 90° or smaller, whereby the second lower electrode **14a** with good step coverage can be formed more efficiently in a later step.

As shown in FIG. **3B,** by a CVD method, a conductive layer **20** is formed on the sides and bottom of the opening **13h** and the upper surface of the third insulating film **13.** The conductive layer **20** is made of, for example, precious metal such as Pt or Ir, or an oxide of this metal, and formed so that the inside of the opening **13h** is not fully filled with the layer.

Then, as shown in FIG. **3C,** by a CMP method, a portion of the conductive layer **20** located on the upper surface of the third insulating film **13** is removed to form the second lower electrode **14a** only within the opening **13h.** That is to say, when viewed three-dimensionally, the second lower electrode 14a has a cylindrical shape formed on the sides and bottom of the opening 13h.

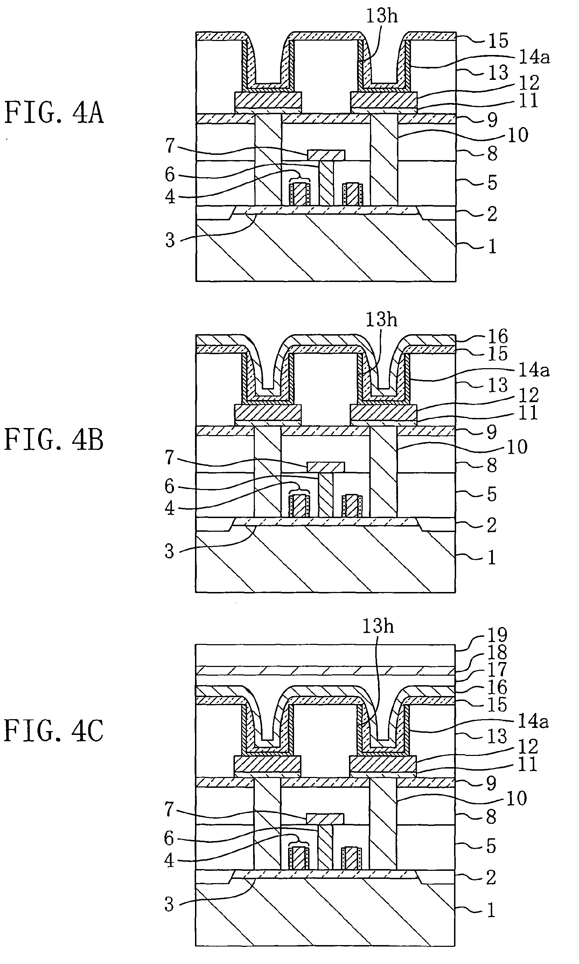

Next, as shown in FIG. 4A, by an MOCVD method, the capacitor insulating film 15 is formed on the second lower electrode 14a and the third insulating film 13 so that the inside of the opening 13h is covered but not filled with the film. The capacitor insulating film **15** is made of a ferroelectric film which is formed of, for example, an SBT (Sr_{1-y}Bi₂₊ₓTa₂O₉, where x satisfies 0≤x and y satisfies y≤1)-based material, a PZT (Pb(ZrₓT₁₋ₓ)O₃, where x satisfies 0≤x≤1)-based material, or a BLT (Bi₄₋ₓLaₓTi₃O₁₂, where x satisfies 0≤x≤1)-based material.

As shown in FIG. **4B**, an upper electrode **16** of precious metal or an oxide of precious metal is formed on the capacitor insulating film 15. The precious metal employed therefor is, for example, Pt or Ir.

Subsequently, as shown in FIG. 4C, the fourth insulating film 17 is formed on the upper electrode 16 so that the opening 13h is filled with the film, and then on the fourth insulating film 17, the second hydrogen barrier film 18 and the fifth insulating film 19 are sequentially formed from bottom to top.

As described above, with the method for fabricating a semiconductor device according to the first embodiment of the present invention, the above-mentioned dielectric memory device according to the first embodiment can be fabricated. Moreover, by forming the conductive film 20 on the third insulating film 13 and the sides and bottom of the opening 13h (see FIG. 3B) and then removing, by a CMP method, the portion of the conductive layer 20 located on the upper surface of the third insulating film 13 (see FIG. 3C), the second lower electrode 14a can be formed only within the opening 13h in a self-aligned manner. This eliminates the necessity to allow an alignment margin used for patterning the lower electrode. Therefore, miniaturization of the capacitor cell in a horizontal direction along the main surface of the semiconductor substrate 1 can be attained by an area corresponding to the eliminated alignment margin.

Furthermore, with the dielectric memory device and its fabrication method thereof according to the first embodiment described above, reduction of the oxygen barrier film **11** formed below the first lower electrode **12** can be prevented. As for this point, in the conventional example, a photoresist having been used for the patterning has to be removed by ashing or the like after processing (patterning) of the lower electrode. Since photoresist contains a large number of C-H groups, C-H bondings in these groups are cut during the ashing to produce hydrogen. The produced hydrogen, however, reduces, for example, the underlying oxygen barrier film of a conductive oxide or the lower electrode if the lower electrode is made of a conductive oxide. This causes the trouble in which the oxygen barrier property decreases or in which excessive metal components produced by the reduction diffuse in the ferroelectric film to increase leakage current. However, with the dielectric memory device and its fabrication method thereof according to the first embodiment of the present invention, the second lower electrode **14a** does not have to be patterned, which eliminates the necessity of photoresist ashing. Therefore, in forming the second lower electrode **14b,** the occurrence of reduction of the oxygen barrier film **11** can be avoided.

Moreover, in conventional techniques, a hard mask may be used when the lower electrode is processed. However, the hard mask provided within the opening for capacitor element formation is formed to extend along the wall portion of the opening, so that after the processing of the lower electrode, it is difficult to remove the mask by a dry etching method that is an anisotropic etching. Even in the case of employing a wet etching method that is an isotropic etching, it is difficult for an adequate amount of chemical solution to enter the fine opening for capacitor element formation. Therefore, it is difficult to fully remove the hard mask. Because of the mask still remaining therewithin, the problem will arise in which the remaining mask has an adverse effect on a later step of forming the capacitor insulating film. However, with the dielectric memory device and its fabrication method thereof according to the first embodiment of the present invention, the second lower electrode **14a** does not have to be patterned. Therefore, the problem mentioned above can be avoided.

Furthermore, the opening for capacitor element formation is concave in the conventional example. Therefore, in the step of etching the lower electrode covering the concave portion, the concave portion affects the thickness of the photoresist to be used in this etching, so that this thickness becomes ununiform to create a standing wave effect. This effect has an influence on the lithography to hinder a high-resolution patterning. However, with the dielectric memory device and its fabrication method thereof according to the first embodiment of the present invention, the second lower electrode 14a does not have to be patterned. Therefore, the problem mentioned above can be avoided.

### (Second Embodiment)

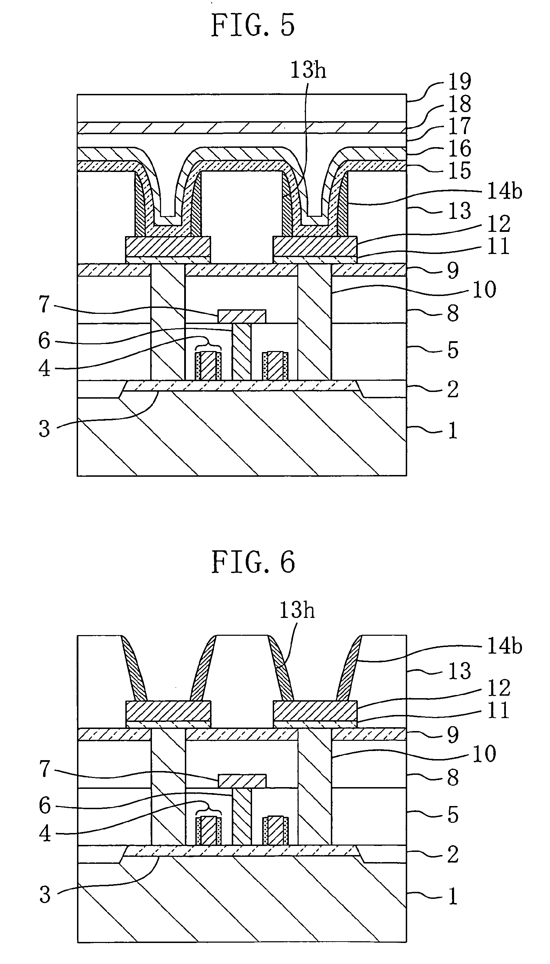

A dielectric memory device according to a second embodiment of the present invention will be described below with reference to FIG. 5. FIG. 5 is a sectional view showing main parts of the structure of the dielectric memory device according to the second embodiment of the present invention. Hereinafter, the components of the dielectric memory device according to the second embodiment of the present invention that are the same as those of the dielectric memory device according to the first embodiment of the present invention retain the same reference numerals, so that detailed description thereof will be omitted.

Referring to FIG. 5, the dielectric memory device according to the second embodiment of the present invention differs in the shape of a second lower electrode **14b** from the above-described dielectric memory device according to the first embodiment of the present invention. To be more specific, the second lower electrode **14b** has the shape in which a portion thereof formed on the sides of the opening (hole) **13h** has a thickness increasing downward from the top of the opening **13h,** that is, a so-called sidewall shape. As another difference point, unlike the first embodiment, the second lower electrode **14b** is not formed on the bottom of the opening 13h, but formed only on the sides of the opening 13h.

As shown in FIG. 5, in the dielectric memory device according to the second embodiment of the present invention, the second lower electrode 14b of sidewall shape is formed only on the sides of the opening 13h, and the capacitor insulating film 15 and the upper electrode 16 are sequentially formed, from bottom to top, on the second lower electrode 14b and a portion of the first lower electrode 12 exposed in the opening 13h.

As shown above, in the dielectric memory device according to the second embodiment of the present invention, the second lower electrode 14b has the shape in which the side wall thereof has a smooth taper expanding upward from the bottom. Therefore, the capacitor insulating film 15 of a ferroelectric film and the upper electrode 16 that will be formed subsequently have excellent step coverages. Thus, with the dielectric memory device according to the second embodiment, a local concentration of an electric field on the vicinity of a mouth of the opening 13h can be released and concurrently the reliability characteristics of the ferroelectric film can be improved. Moreover, the second lower electrode 14b is formed only within the opening 13h, which eliminates the necessity to allow an alignment margin used for patterning the lower electrode. Therefore, miniaturization of the capacitor cell in a horizontal direction along the main surface of the semiconductor substrate 1 can be attained by an area corresponding to the eliminated alignment margin.

In the second embodiment, as shown in FIG. 6, the opening 13h formed through the third insulating film 13 may be an opening with a tapered shape whose side has a taper angle of 80 to 90°. With this structure, even as compared with the structure previously shown in FIG. 5, this taper angle range is no influence on formation of the second lower electrode 14b with a sidewall shape and the top of the opening 13h has a greater diameter than the bottom thereof. Therefore, the step coverages of the second lower electrode 14b, the capacitor insulating film 15 of a ferroelectric film, and the upper electrode 16 can be further improved.

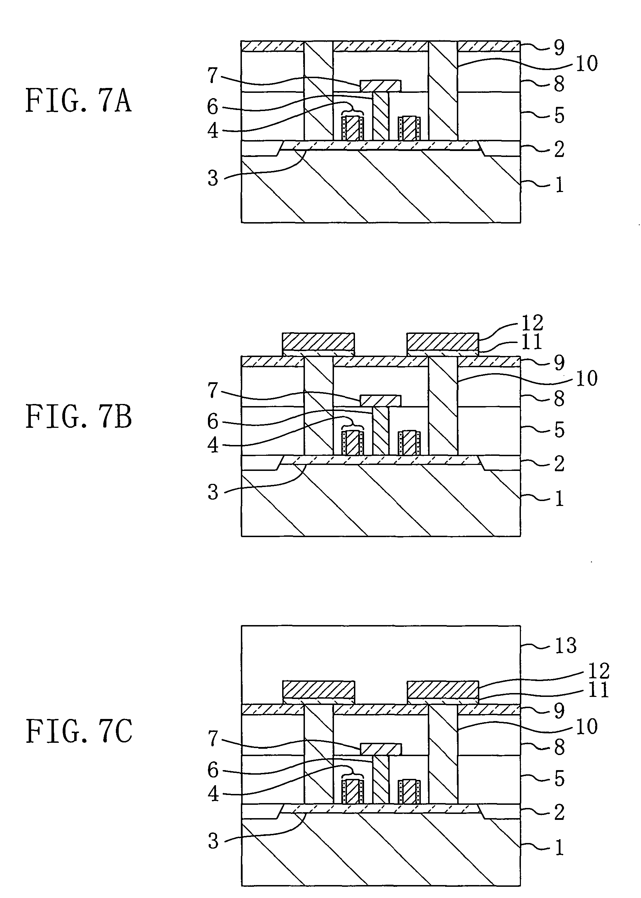

Hereinafter, a method for fabricating a dielectric memory device according to the second embodiment of the present invention will be described with reference to FIGS. **7A** to **7C, 8A** to **8C,** and **9A** to **9C.** Specifically, the method for fabricating a dielectric memory device according to the second embodiment of the present invention is a fabrication method of the semiconductor device of the second embodiment previously shown in FIG. 5, and the description of the process steps that are similar to those of the method for fabricating a semiconductor device of the first embodiment shown in FIGS. **2A** to **2C, 3A** to **3C,** and **4A** to **4C** will be omitted. FIGS. **7A** to **7C, 8A** to **8C,** and **9A** to **9C** are sectional views showing main process steps of the method for fabricating a semiconductor device according to the second embodiment of the present invention.

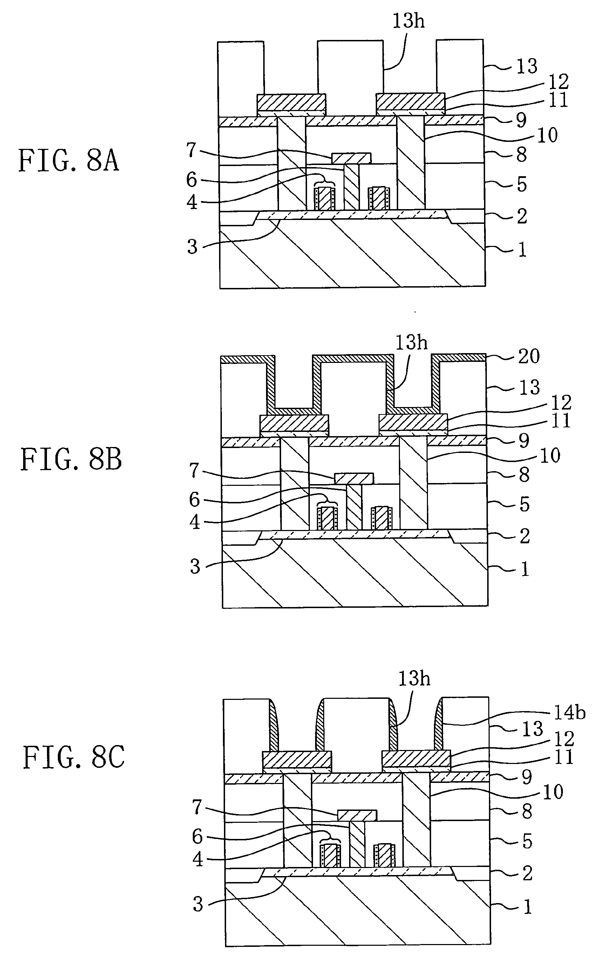

First, FIGS. **7A** to **7C** and **8A** and **8B** show process steps similar to those shown in FIGS. **2A** to **2C** and **3A** and **3B** of the first embodiment, respectively.

Next, as shown in FIG. **8C,** in order for the conductive film **20** to remain only within the opening **13h,** a portion of the conductive film **20** lying outside the opening **13h** and on top of the third insulating film **13** is removed by an etch back method to let the conductive film **20** remain only within the opening **13h.** In this removal, a portion of the conductive film **20** located on an upper part of the sides of the opening is partly etched. Thereby, on the sides of the opening **13h,** the second lower electrode **14b** of cylindrical, sidewall shape is formed in a self-aligned manner.

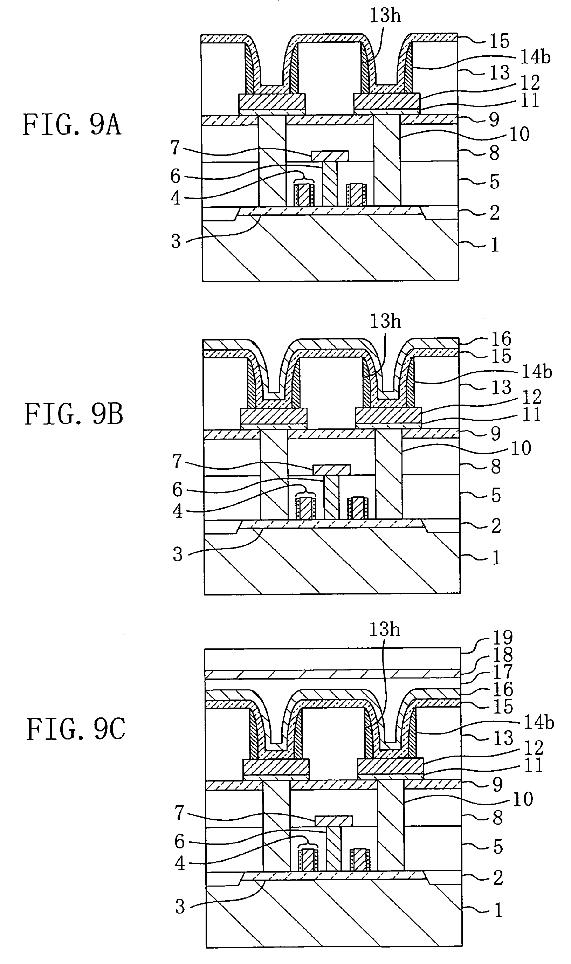

Subsequently, the process steps shown in FIGS. **9A** to **9C** are similar to those described using FIGS. **4A** to **4C,** respectively.

As described above, with the method for fabricating a dielectric memory device according to the second embodiment of the present invention, the dielectric memory device in FIG. **5** according to the second embodiment can be fabricated. Moreover, the portion of the conductive film **20** lying outside the opening **13h** and on top of the third insulating film **13** is removed by etching, whereby the second lower electrode **14b** of sidewall shape can be formed only on the sides of the opening **13h** in a self-aligned manner. This eliminates the necessity to allow an alignment margin used for patterning the lower electrode. Therefore, miniaturization of the capacitor cell in a horizontal direction along the main surface of the semiconductor substrate **1** can be attained by an area corresponding to the eliminated alignment margin.

Moreover, since the portion of the second lower electrode **14b** formed on the sides of the opening **13h** has a thickness decreasing upward from the bottom of the opening **13h,** the opening **13h** having been formed with the second lower electrode **14b** has an upward-expanding shape. With this shape, when the capacitor insulating film **15** of a ferroelectric film is formed on the second lower electrode **14b** by an MOCVD method, the material gas for this film easily enters the inside of the opening **13h.** Therefore, the capacitor insulating film **15** with good step coverage can be formed.

With the fabrication method of the second embodiment, the structure previously shown in FIG. **6** can also be fabricated. To be more specific, the opening **13h** is formed on the third insulating film **13** so that the sides thereof are tapered, whereby the upper portion of the opening **13h** has a more increased diameter than the lower portion. Therefore, the material gas used for forming the capacitor insulating film **15** of a ferroelectric film can enter the inside of the opening **13h** with efficiency. This forms the capacitor insulating film 15 with further excellent step coverage.

In addition, the second lower electrode **14b** can also be annealed in an oxygen atmosphere after the step of forming the second lower electrode **14b** by an etch back (see FIG. **8C).** Annealing of the second lower electrode **14b** in an oxygen atmosphere can strengthen the bonding power of the second lower electrode **14b** that has been weakened once by the etch back. For example, if the second lower electrode **14b** is made of a conductive oxide, a phenomenon arises in which the etch back eliminates some of oxygen forming the conductive oxide. However, by this annealing, the conductive oxide with some of oxygen eliminated is reoxidized or oxygen is added to that conductive oxide, so that the second lower electrode **14b** can exert a sufficient function as an electrode.

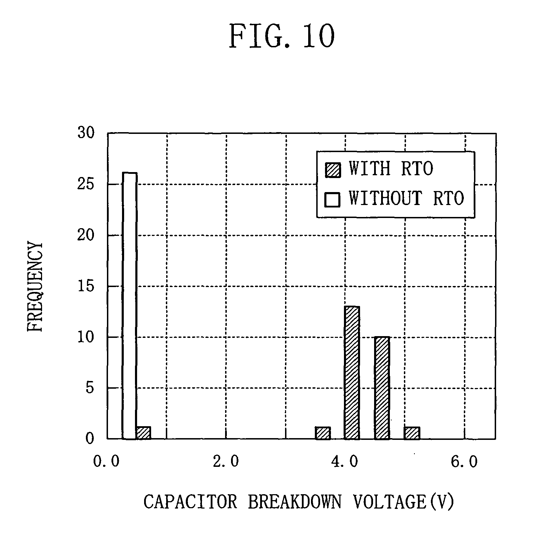

FIG. **10** shows the breakdown voltage capability of a ferroelectric capacitor using an SBT film as a ferroelectric film in the case where the second lower electrode **14b** made of an IrO₂ film is annealed at 650°C for one minute. As is apparent from FIG. **10,** in the case where annealing is not performed (WITHOUT RTO (rapid thermal oxidation) in FIG. **10),** it is found that the breakdown voltage of the capacitor is short-circuited. On the other hands, in the case where annealing is performed (WITH RTO in FIG. **10),** it is found that the short circuit thereof can be prevented. This short circuit is caused as follows: part of the etched-back IrO₂ film is changed into an Ir film, and a subsequent heat treatment diffuses Ir into the ferroelectric film to cause short circuit. As is understood from the above, the second lower electrode **14b** can be annealed to enhance the stability thereof as an electrode, and thereby a ferroelectric capacitor with stable characteristics can be provided.

With the dielectric memory device and its fabrication method according to the second embodiment, reduction of the oxygen barrier film **11** formed below the first lower electrode **12** can be prevented. As for this point, in the conventional example, a photoresist having been used for the patterning has to be removed by ashing or the like after processing (patterning) of the lower electrode. Since photoresist contains a large number of C-H groups, C-H bondings in these groups are cut during the ashing to produce hydrogen. The produced hydrogen, however, reduces, for example, the underlying oxygen barrier film of a conductive oxide or the lower electrode if the lower electrode is made of a conductive oxide. This causes the trouble in which the oxygen barrier property decreases or in which excessive metal components produced by the reduction diffuse in the ferroelectric film to increase leakage current. However, with the dielectric memory device and its fabrication method thereof according to the second embodiment of the present invention, the second lower electrode **14a** does not have to be patterned, which eliminates the necessity of photoresist ashing. Therefore, in forming the second lower electrode **14b,** the occurrence of reduction of the oxygen barrier film **11** can be avoided.

Moreover, in conventional techniques, a hard mask may be used when the lower electrode is processed. However, the hard mask provided within the opening for capacitor element formation is formed to extend along the wall portion of the opening, so that after the processing of the lower electrode, it is difficult to remove the mask by a dry etching method that is an anisotropic etching. Even in the case of employing a wet etching method that is an isotropic etching, it is difficult for an adequate amount of chemical solution to enter the fine opening for capacitor element formation. Therefore, it is difficult to fully remove the hard mask. Because of the mask still remaining therewithin, the problem will arise in which the remaining mask has an adverse effect on a later step of forming the capacitor insulating film. However, with the dielectric memory device and its fabrication method thereof according to the second embodiment of the present invention, the second lower electrode **14a** does not have to be patterned. Therefore, the problem mentioned above can be avoided.

Furthermore, the opening for capacitor element formation is concave in the conventional example. Therefore, in the step of etching the lower electrode covering the concave portion, the concave portion affects the thickness of the photoresist to be used in this etching, so that the thickness becomes ununiform to create a standing wave effect. This effect has an influence on the lithography to hinder a high-resolution patterning. However, with the dielectric memory device and its fabrication method thereof according to the second embodiment of the present invention, the second lower electrode **14a** does not have to be patterned. Therefore, the problem mentioned above can be avoided.

### (Third Embodiment)

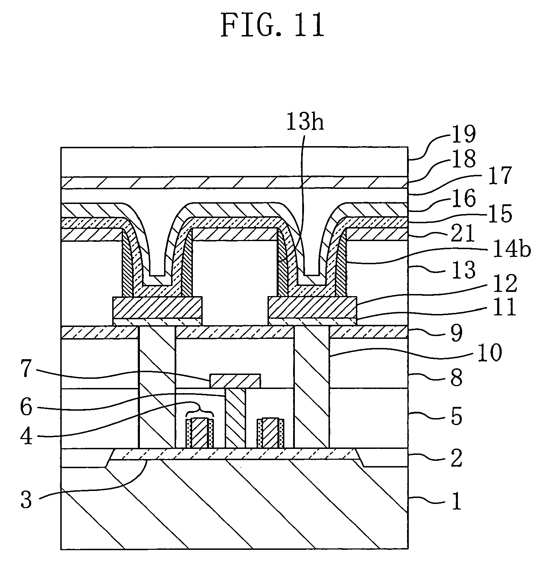

A dielectric memory device according to a third embodiment of the present invention will be described below with reference to FIG. **11.** FIG. **11** is a sectional view showing main parts of the structure of the dielectric memory device according to the third embodiment of the present invention. Hereinafter, the components of the dielectric memory device according to the third embodiment of the present invention that are the same as those of the dielectric memory devices according to the first and second embodiments of the present invention retain the same reference numerals, so that detailed description thereof will be omitted.

Referring to FIG. **11,** the dielectric memory device according to the third embodiment of the present invention differs from the above-described dielectric memory device according to the second embodiment of the present invention in that a film **21** for stopping etching (an etch stop film **21)** is formed on top of the third insulating film **13.** With this difference, the opening **13h** is formed to penetrate the etch stop film **21** and the third insulating film **13.** This etch stop film **21** is made of a material that is more difficult to etch than the underlying third insulating film **13,** such as a SiN film or a SiON film.

As shown above, with the dielectric memory device according to the third embodiment of the present invention, the same effects as those of the dielectric memory device according to the second embodiment described above can be exerted. In addition to this, since around the mouth of the opening **13h,** the capacitor insulating film **15** is formed on the etch stop film **21,** the adhesion of the capacitor insulating film **15** to the underlying film is enhanced as compared with the case where the capacitor insulating film **15** is formed on the third insulating film **13.** Furthermore, since the etch stop film **21** is formed on the third insulating film **13,** the material that matches with crystal growth of the ferroelectric film (for example, their lattice constants are similar) better than the third insulating film **13** can be selected for the etch stop film **21.** On the other hand, if the etch stop film **21** is not formed, it is necessary to make the third insulating film 13 of the material that has good adhesion to and good matching with the capacitor insulating film **15.** However, the third insulating film **13** has to be formed with a relatively deep opening, so that there is a high possibility that the material excelling in both adhesion and matching cannot be selected. Therefore, with the structure of the dielectric memory device according to the third embodiment of the present invention, a relatively deep opening can be formed through the third insulating film **13,** and the capacitor insulating film **15** having excellent adhesion to and excellent matching with the underlying film can be formed. That is to say, this dielectric memory device can increase the flexibility in selection of the material suited for various targets demanded of the opening **13h** or the capacitor insulating film 15.

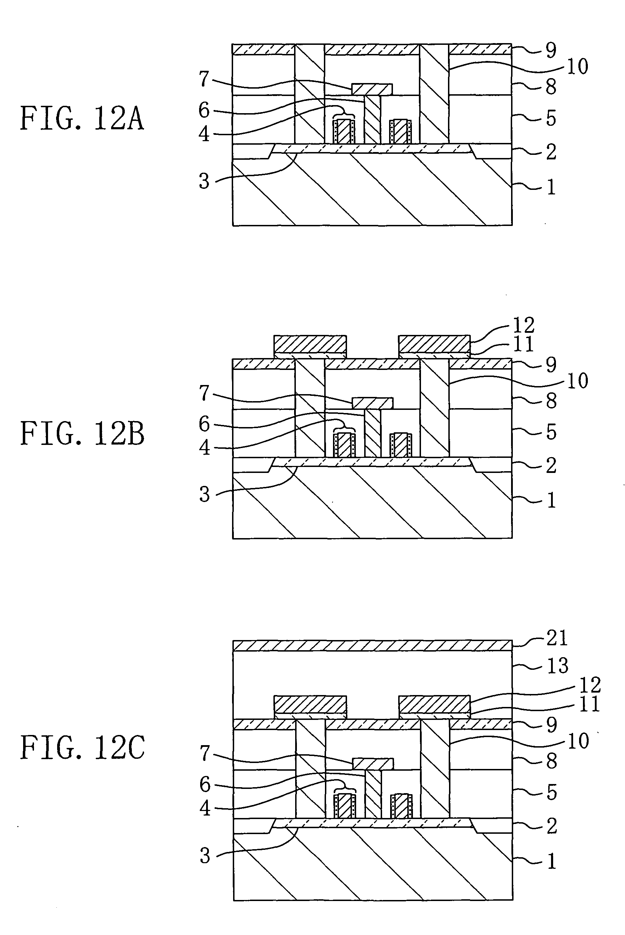

Hereinafter, a method for fabricating a dielectric memory device according to the third embodiment of the present invention will be described with reference to FIGS. **12A** to **12C, 13A** to **13C,** and **14A** to **14C.** Specifically, the method for fabricating a dielectric memory device according to the third embodiment of the present invention is a fabrication method of the semiconductor device of the third embodiment previously shown in FIG. **11,** and the description of the process steps that are similar to those of the method for fabricating a semiconductor device of the second embodiment shown in FIGS. **7A** to **7C, 8A** to **8C,** and **9A** to **9C** will be omitted. FIGS. **12A** to **12C, 13A** to **13C,** and **14A** to 14C are sectional views showing main process steps of the method for fabricating a semiconductor device according to the third embodiment of the present invention.

First, FIGS. **12A** and **12B** show process steps similar to FIGS. **7A** and **7B** described above, respectively.

Next, as shown in FIG. **12C,** over the first hydrogen barrier film **9,** the third insulating film **13** is formed to cover the oxygen barrier film **11** and the first lower electrode **12,** and then the surface of the third insulating film **13** is planarized by CMP or the like. Subsequently, the etch stop film **21** of, for example, SiN or SiON with a thickness of about 50 to 100 nm is formed on the third insulating film **13,** and then the surface of the etch stop film **21** is planarized by CMP or the like.

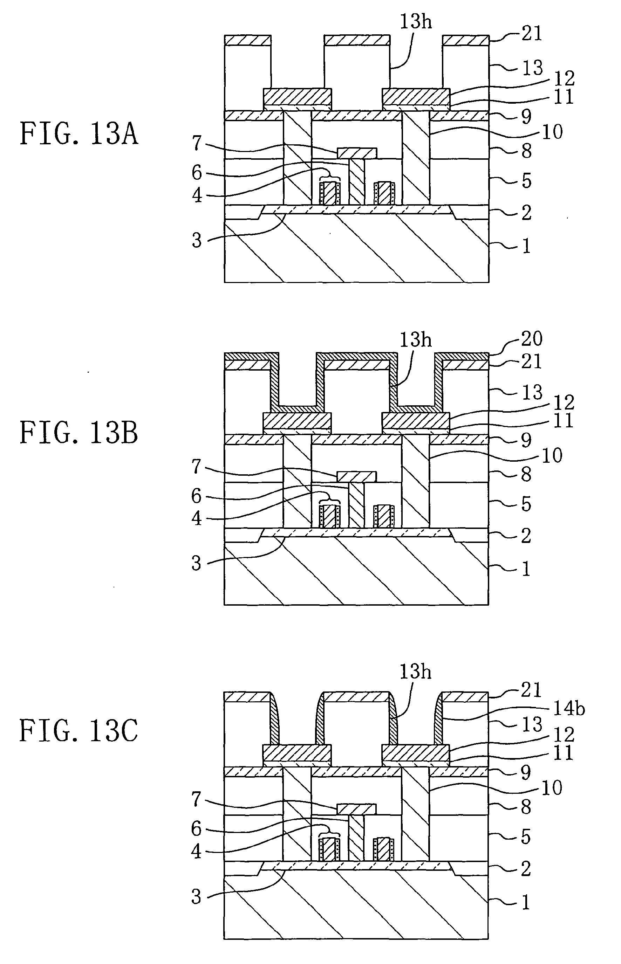

As shown in FIG. **13A,** by lithography and dry etching methods, the opening **13h** exposing the upper surface of the first lower electrode **12** is formed through the etch stop film **21** and the third insulating film **13.**

Then, as shown in FIG. **13B,** the conductive layer **20** is formed on the upper surface of the etch stop film **21** and the sides and bottom of the opening **13h.** The conductive layer **20** is made of, for example, precious metal such as Pt or Ir, or an oxide of this metal, and formed so that the inside of the opening **13h** is not fully filled with the layer.

As shown in FIG. **13C,** a portion of the conductive film **20** lying outside the opening **13h** and on top of the etch stop film **21** is removed by an etch back method to let the conductive film **20** remain only within the opening **13h.** Thereby, on the sides of the opening **13h,** the second lower electrode **14b** of cylindrical, sidewall shape is formed in a self-aligned manner.

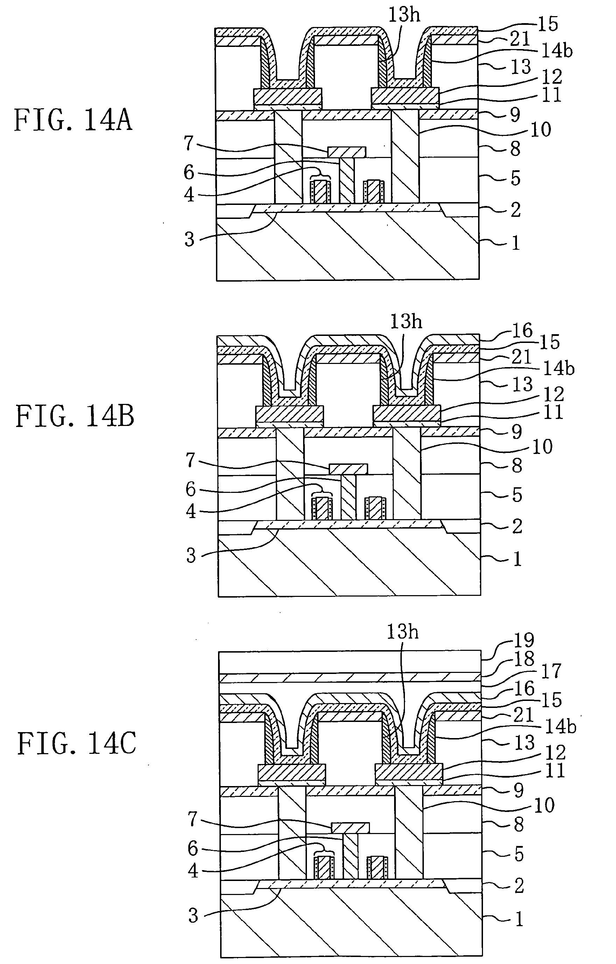

Subsequently, the process steps shown in FIGS. **14A** to **14C** are similar to those described using FIGS. **9A** to **9C,** respectively.

As described above, with the method for fabricating a dielectric memory device according to the third embodiment of the present invention, the dielectric memory device in FIG. **11** according to the third embodiment can be fabricated. Further, in forming the second lower electrode **14b,** etching is performed on the entire surface of the substrate. During this etching, while the upper portion of the opening **13h** is also subjected to etching, the etch stop film **21** functions as a film for stopping etching to suppress the amount of over-etching of the upper portion of the opening **13h.** Thus, the height of the opening **13h** will not decrease and the second lower electrode **14b** will not protrude upward from the inside of the opening **13h.** Therefore, variations in the height of the opening **13h** can be reduced and variations in cell capacitance accompanied with the height variations can be prevented.

### <Modification of Method for Fabricating Dielectric Memory Device according to Second and Third Embodiments>

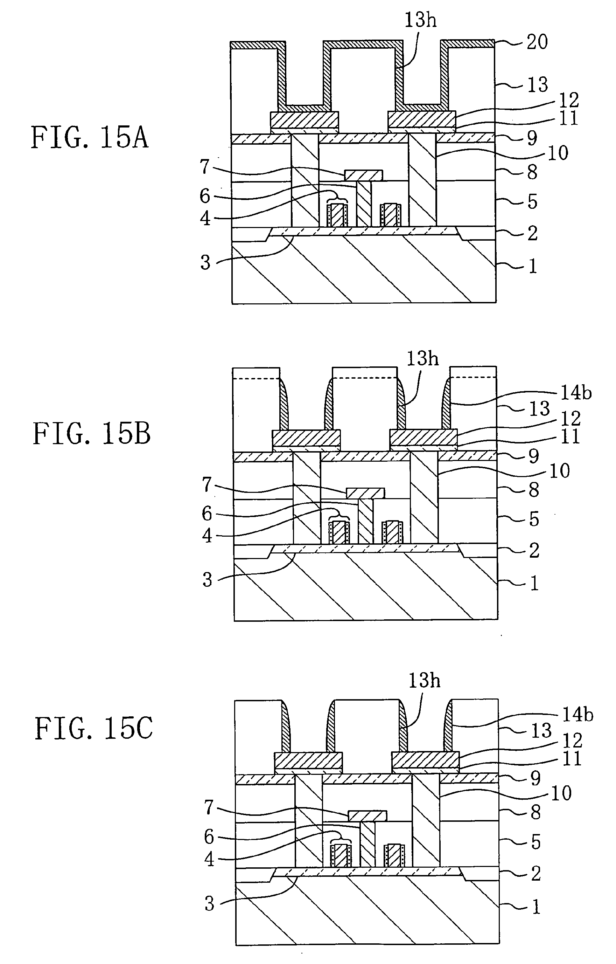

A modification of the method for fabricating a dielectric memory device according to the second and third embodiments will be described below with reference to FIGS. **15A** to **15C.** Note that the description of common process steps to this modification and the described method for fabricating a dielectric memory device according to the second and third embodiments will be omitted. FIGS. **15A** to **15C** are sectional views showing main process steps of the method for fabricating a dielectric memory device according to this modification.

First, in a similar manner to the above description using FIGS. **7A** to **7C** and **8A** and **8B**, the structure shown in FIG. **15A** is fabricated.

Next, as shown in FIG. **15B,** the entire surface of the substrate is etched back to remove a portion of the conductive film **20** lying on the third insulating film **13** and to let the conductive film **20** remain only within the opening **13h.** Thus, the second lower electrode **14b** of cylindrical, sidewall shape is formed. In this step, the etching condition is set so that the conductive film **20** targeted for this etching is etched more than the third insulating film **13.**

In this etching, over-etching of a certain amount is required in order to completely remove the conductive film 20 **on** the third insulating film **13.** As a result of this, as shown in FIG. **15B,** a portion of the conductive film **20** remaining within the opening **13h** is etched to an excessive degree to set back the top end of the second lower electrode **14b** to the level below the top edge of the opening **13h.** That is to say, the second lower electrode **14b** is formed to have a level below the dotted line shown in FIG. **15B.**

Subsequently, as shown in FIG. **15C,** by a CMP method or an etch back method, a portion of the third insulating film **13** is removed which is located above the dotted line shown in FIG. **15B** and which does not contribute to the cell capacitance.

As described above, in the modification of the method for fabricating a dielectric memory device according to the second and third embodiments, the portion of the third insulating film **13** is removed which forms the opening **13h** and which does not contribute to the cell capacitance. Thereby, the opening **13h** with a height necessary for contribution to the cell capacitance is formed. This reduces the aspect ratio of the opening **13h,** so that in later steps, the capacitor insulating film **15** and the upper electrode **16** can be formed with good step coverage.

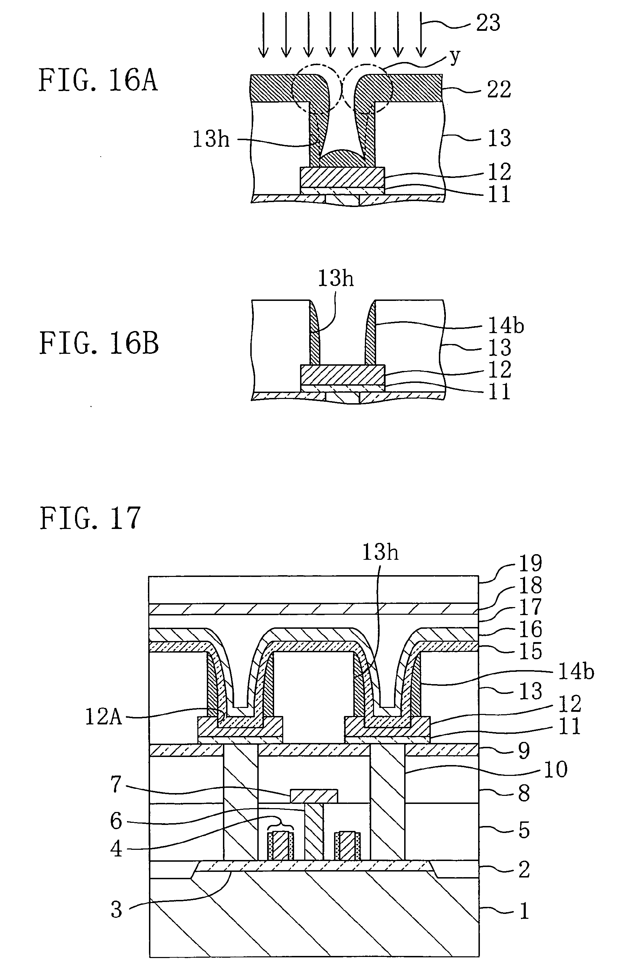

In the above-mentioned method for fabricating a dielectric memory device according to the second and third embodiments, description has been made of the case where the conductive film **20** which will be formed into the second lower electrode **14b** is formed by a CVD method. However, even in the case where a sputtering method is used in these embodiments, the same effects as the second and third embodiments can be exerted. A concrete description of this will be made with reference to FIGS. **16A** and **16B.** FIGS. **16A** and **16B** are sectional views showing main process steps of the case where the second lower electrode **14b** is formed by a sputtering method. Note that the description of the components which are in common with the second and third embodiments and which are not shown in FIGS. **16A** and **16B** will be omitted.

As shown in FIG. **16A,** by a sputtering method, a conductive film **22** is formed on the third insulating film **13** including the inside of the opening **13h.** Note that since a sputtering method is generally inferior in step coverage to a CVD method, as shown in FIG. **16A,** the conductive film **22** overhangs at an opening edge region y of the opening **13h.**

Next, as shown in FIG. **16B,** the entire surface of the substrate is etched back. In this case, an etching gas **23** used has directivity given. Thus, the overhung portion itself at the opening edge region y serves as a mask, so that a portion of the conductive film **22** located within the opening **13h** and below the opening edge region y is not etched. Therefore, the conductive film **22** can intentionally be let to remain only on the sides of the opening **13h,** whereby the second lower electrode **14b** can be formed only within the opening **13h.**

As is apparent from the above, even in the case of employing a sputtering method, the second lower electrode **14b** of cylindrical, sidewall shape can be formed easily on the sides of the opening **13h** as in the case of employing a CVD method. Therefore, also in the case of employing a sputtering method, the occurrence of a break in a conducting line resulting from an overhung shape can be prevented.

### (Fourth Embodiment)

A dielectric memory device according to a fourth embodiment of the present invention will be described below with reference to FIG. **17.** FIG. **17** is a sectional view showing main parts of the structure of the dielectric memory device according to the fourth embodiment of the present invention. Hereinafter, the components of the dielectric memory device according to the fourth embodiment of the present invention that are the same as those of the dielectric memory device according to the second embodiment of the present invention retain the same reference numerals, so that detailed description thereof will be omitted.

The dielectric memory device according to the fourth embodiment of the present invention is characterized in that the first lower electrode **12** and the second lower electrode **14b** are made of the same material. A fabrication method of the dielectric memory device according to the fourth embodiment is the same as the above-described fabrication method of the dielectric memory device according to the second embodiment.

Referring to FIG. **17,** the center portion of the first lower electrode **12** is formed with a recess **12A** whose sides are continuous with the inclined surface (side wall) of the sidewall shape of the second lower electrode **14b,** and the capacitor insulating film **15** is formed to extend along the inside of the recess **12A** and the inclined surface of the second lower electrode **14b.** In this structure, the first lower electrode **12** and the second lower electrode **14b** (conductive film **20)** are made of the same material such as an IrO₂ film.

Thus, the first lower electrode **12** and the conductive film **20** are made of the same material. Therefore, in the step of etching the conductive film **20** (see, for example, FIG. **8C** shown above), the first lower electrode **12** is over-etched to recess the center portion of the first lower electrode **12** (to form the recess **12A).**

As described above, with the dielectric memory device according to the fourth embodiment of the present invention, it is sufficient only for the selected material for one electrode to consider the lattice matching during crystal growth, the matching with a ferroelectric film in case of impurity diffusion from the electrode, or the like. Thus, as compared with the case where the first lower electrode **12** and the conductive film 20 forming the second lower electrode **14b** differ in the selected material, the flexibilities of other processes are not restricted, and the interaction between the different electrode materials does not have to be considered.

Moreover, the center portion of the first lower electrode **12** is formed with the recess **12A,** whereby the area of the first lower electrode **12** contributing to the cell capacitance increases. This provides an increased effective height of the capacitor component, so that the cell capacitance can be enhanced.

### (Fifth Embodiment)

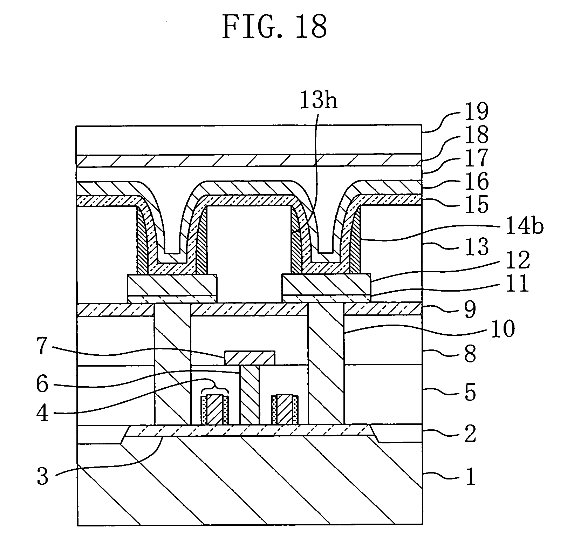

A dielectric memory device according to a fifth embodiment of the present invention will be described below with reference to FIG. **18.** FIG. **18** is a sectional view showing main parts of the structure of the dielectric memory device according to the fifth embodiment of the present invention. Hereinafter, the components of the dielectric memory device according to the fifth embodiment of the present invention that are the same as those of the dielectric memory device according to the second embodiment of the present invention retain the same reference numerals, so that detailed description thereof will be omitted.

The dielectric memory device according to the fifth embodiment of the present invention is characterized, unlike the device of the fourth embodiment shown above, in that the first lower electrode **12** and the second lower electrode **14b** are made of different materials. A fabrication method of the dielectric memory device according to the fifth embodiment is the same as the above-described fabrication method of the dielectric memory device according to the second embodiment.

Referring to FIG. **18,** the first lower electrode **12** is made of, for example, an IrO₂ film, and the second lower electrode **14b** (the conductive film **20)** is made of, for example, a Pt film.

As shown above, in the dielectric memory device according to the fifth embodiment of the present invention, the first lower electrode **12** and the second lower electrode 14b differ in selected material. Therefore, for the first lower electrode **12,** the material capable of sufficiently performing the function as a layer for protecting the storage node contact plug, such as the function as an oxygen barrier film or a film for preventing impurity diffusion can be selected. The reason for this is that since the first lower electrode **12** makes up only a small percentage of the area of the lower electrode in the entire cell, it is sufficient that it merely has at least the function as a conductive film (for example, the function as a conductive oxygen barrier film).

Moreover, a dry etching condition having etching selectivity to the first lower electrode **12** can be selected for an etching for forming the second lower electrode **14b** of cylindrical, sidewall shape. Thus, as compared with the case where the first lower electrode **12** and the second lower electrode **14b** are made of the same material, the occurrence of variations in cell capacitance resulting from over-etching is reduced, which is effective for various cell designs.

In the fourth and fifth embodiments, for the materials for the first and second lower electrodes **12** and **14b,** it is recommendable to select a material suited to the viewpoint such as the degree of difficulty of processing or controllability of variations in cell capacitance, or to application of the device.

### (Sixth Embodiment)

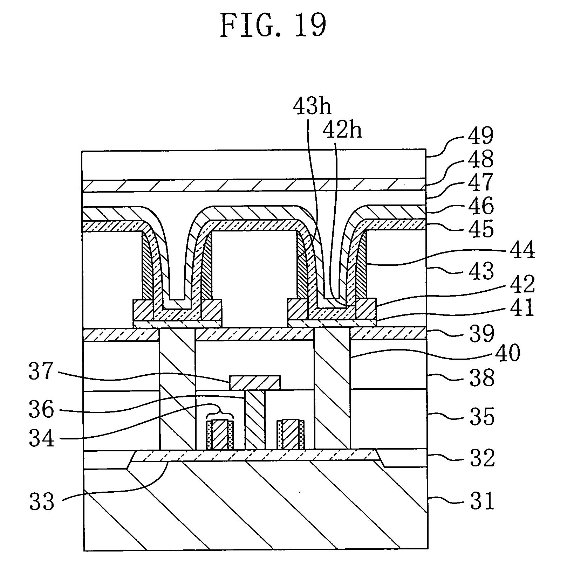

A dielectric memory device according to a sixth embodiment of the present invention will be described with reference to FIG. **19.** FIG. **19** is a sectional view showing main parts of the structure of the dielectric memory device according to the sixth embodiment of the present invention.

Referring to FIG. **19,** an impurity diffusion layer **33** is formed in an element formation region defined by an isolation region (STI) **32** in a semiconductor substrate **31.** A gate electrode **34** is formed on the element formation region of the semiconductor substrate **31.** Thus, the impurity diffusion layer **33** and the gate electrode **34** constitute a transistor. Over the entire surface of the semiconductor substrate **31,** a first insulating film **35** is formed to cover the transistor. Through the first insulating film **35,** a first contact plug **36** is formed which penetrates the first insulating film **35** to connect the lower end thereof to the impurity diffusion layer **33.** On the first insulating film **35,** a bit line **37** is formed to connect the lower surface thereof to the upper end of the first contact plug **36.** On the first insulating film **35,** a second insulating film **38** is formed to cover the bit line **37,** and a first hydrogen barrier film **39** is formed on the second insulating film **38.**

Through the first hydrogen barrier film **39,** the second insulating film **38,** and the first insulating film **35,** a second contact plug **40** is formed which penetrates these films to connect the lower end thereof to the impurity diffusion layer **33.** An oxygen barrier film **41** exhibiting conductivity is formed on the first hydrogen barrier film **39.** The lower surface of the oxygen barrier film **41** is connected to the upper end of the second contact plug **40.** On the oxygen barrier film **41,** a first lower electrode **42** is formed which has a recess **42h.** On the first hydrogen barrier film **39,** a third insulating film **43** with an opening **43h** is formed to cover the oxygen barrier film **41** and the first lower electrode **42.** Note that the first contact plug **36** is a bit line contact and the second contact plug **40** is a storage node contact.

A second lower electrode **44** is formed only on the sides of the opening **43h.** The second lower electrode **44** has a cylindrical, sidewall shape, and the inclined surface of the sidewall shape is continuous with the sides of the recess **42h.** A capacitor insulating film **45** of a ferroelectric film is formed on the sides and bottom of the recess **42h,** the inclined surface of the second lower electrode **44,** and the top surface of the third insulating film **43.** An upper electrode **46** is formed on the capacitor insulating film **45.** Thus, the first lower electrode **42,** the second lower electrode **44,** the capacitor insulating film **45,** and the upper electrode **46** constitute a capacitor. On the upper electrode **46,** a fourth insulating film **47** is formed so that the opening **43h** is filled with the film. On the fourth insulating film **47,** a second hydrogen barrier film **48** and a fifth insulating film **49** are sequentially formed from bottom to top.

In the structure shown above, the oxygen barrier film **41** is, for example, a single-layer film of any one film selected from an Ir film, an IrO₂ film, a TiAIN film, and a TaAlN film, or a multilayer film of two or more films selected from the listed films. The first and second lower electrodes **42** and **44** are made of, for example, precious metal such as Pt or Ir, or an oxide of this metal. The ferroelectric film forming the capacitor insulating film **45** is made of, for example, an SBT-, a PZT-, or a BLT-based material.

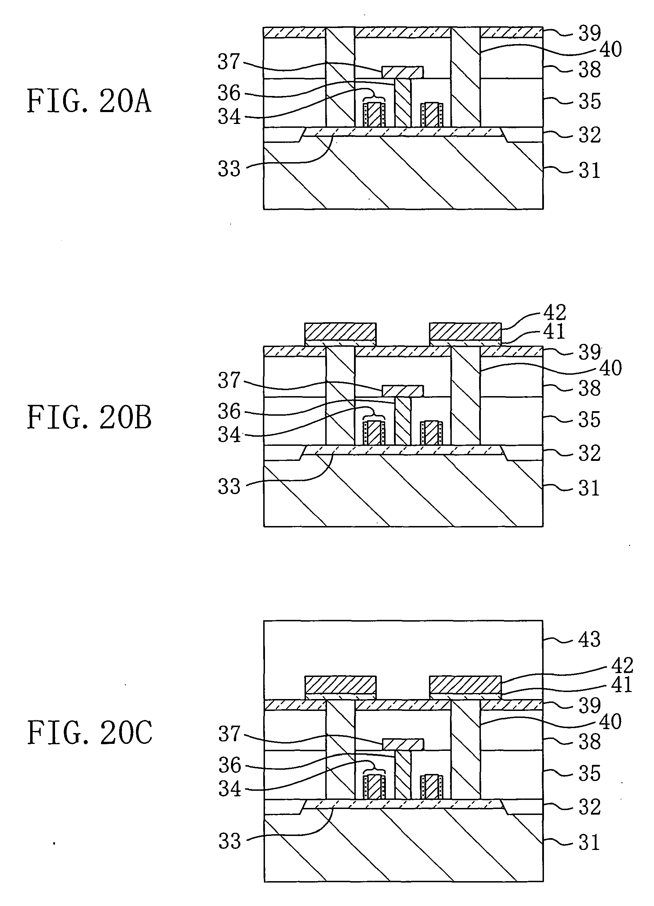

Hereinafter, a method for fabricating a dielectric memory device according to the sixth embodiment of the present invention will be described with reference to FIGS. **20A** to **20C, 21A** and **21B,** and **22A** to **22C.** FIGS. **20A** to **20C, 21A** and **21B,** and **22A** to **22C** are sectional views showing main process steps of the method for fabricating a dielectric memory device according to the sixth embodiment of the present invention. The method for fabricating a dielectric memory device according to the sixth embodiment differs from the fabrication method thereof according to the second embodiment in that the conductive film 20 is not formed within the opening. In the second embodiment, the conductive film 20 is etched to form the second lower electrode in a self-aligned manner. On the other hand, in the sixth embodiment, the first lower electrode is etched to form the second lower electrode in a self-aligned manner.

First, as shown in FIG. **20A,** the transistor composed of the impurity diffusion layer **33** and the gate electrode **34** is formed on a region of the semiconductor substrate **31** defined by the isolation region (STI) **32.** In this structure, over the entire surface of the semiconductor substrate **31,** the first insulating film **35** of, for example, a silicon dioxide (SiO₂) film with a thickness of about 500 to 800 nm is deposited to cover the transistor. Subsequently, through the first insulating film **35,** a first contact hole (not shown) is formed which penetrates the first insulating film **35** to reach the impurity diffusion layer **33,** and then the formed first contact hole is filled with tungsten (W), polysilicon, or the like to form the first contact plug **36** serving as a bit line contact.

Next, a conductive film of W or TiN with a thickness of about 20 to 200 nm is deposited on the first insulating film **35** and the first contact plug **36,** and then the formed conductive film is etched using a desired mask to form the bit line **37** whose lower surface covers the upper end of the first contact plug **36.**

Subsequently, the second insulating film **38** of, for example, a silicon dioxide (SiO₂) film with a thickness of about 500 to 800 nm is deposited on the first insulating film **35**, and then the first hydrogen barrier film **39** of, for example, a silicon nitride (SiN) film with a thickness of about 20 to 100 nm is deposited on the second insulating film 38. Through the first hydrogen barrier film **39,** the second insulating film **38,** and the first insulating film **35,** a second contact hole (not shown) is formed which penetrates these films to reach the impurity diffusion layer **33,** and then the formed second contact hole is filled with tungsten (W), polysilicon, or the like to form the second contact plug **40** serving as a storage node contact.

In the sixth embodiment, in the step shown in FIG. **20A,** the step of forming a cobalt silicide (CoSi₂) layer on the surface of the impurity diffusion layer **33** may be additionally provided. This step can reduce the resistance as compared with the case where no cobalt silicide layer is provided on the surface of the impurity diffusion layer **33,** which prevents delay in circuit operations. In addition, it is also acceptable that the first hydrogen barrier film **39** is not provided depending on the material for the capacitor insulating film to be formed later.

Subsequently to the formation of the second contact plug **40,** as shown in FIG. **20B,** the oxygen barrier film **41** having a thickness of about 20 to 200 nm and exhibiting conductivity is formed on the first hydrogen barrier film **39** and the second contact plug **40** to connect the lower surface to the upper end of the second contact plug **40.** In this formation, the lower surface of the oxygen barrier film **41** is connected to the upper end of the second contact plug **40.** In this structure, the oxygen barrier film **41** is, for example, a single-layer film of any one film selected from an Ir film, an IrO₂ film, a TiAIN film, and a TaAlN film, or a multilayer film of two or more films selected from the listed films. The oxygen barrier film **41** is provided to prevent oxidation of the second contact plug **40** during a thermal treatment in an oxygen atmosphere for crystallization of a ferroelectric film forming the capacitor insulating film **45** that will be described later. If the oxygen barrier film **41** is made of a TiAIN film, the oxygen barrier film **41** functions not only as an oxygen barrier film but also as a hydrogen barrier film. If the ferroelectric film forming the capacitor insulating film **45** that will be described later is crystallized at a sufficiently low temperature, the oxygen barrier film **41** does not have to be provided. Next, on the formed oxygen barrier film **41,** the first lower electrode **42** with a thickness of about 100 to 500 nm is formed which is made of, for example, precious metal such as Pt or Ir, or an oxide of this metal.

In this step, in accordance with the thickness of the first lower electrode **42,** the depth of the recess **42h** that will be formed later can be adjusted. For example, if the first lower electrode **42** is thickened to increase the depth of the recess **42h,** the capacitance of a capacitor element to be finally fabricated can be increased. Therefore, it is recommended that the thickness of the first lower electrode **42** is determined in consideration of a necessary cell capacitance.

As shown in FIG. **20C,** over the entire surface of the first hydrogen barrier film **39,** the third insulating film **43** of, for example, SiO₂ with a thickness of about 500 to 1000 nm is deposited to cover the oxygen barrier film **41** and the first lower electrode **42,** and then the surface of the third insulating film **43** is planarized by a CMP method or the like.

In this step, the depth of the opening **43h** that will be formed later can be adjusted in accordance with the thickness of the third insulating film **43** remaining after the planarization by a CMP method. For example, if the remaining third insulating film **43** is thickened to increase the depth of the opening **43h,** the capacitance of a capacitor element to be finally fabricated can be increased. The thickness of the remaining third insulating film **43** is a value directly linked to the cell capacitance. Therefore, it is recommended that, as in the case of the thickness of the first lower electrode **42,** the thickness of the remaining third insulating film **43** is determined in consideration of a necessary cell capacitance.

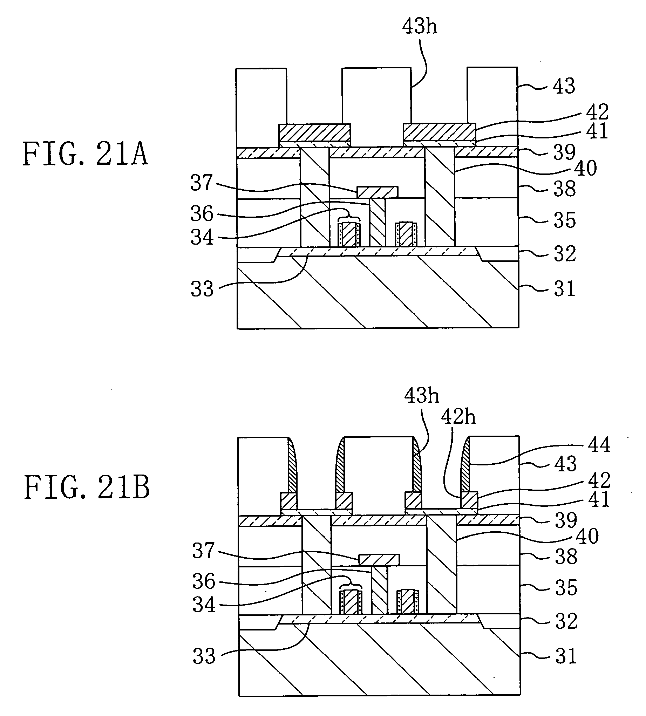

Subsequently, as shown in FIG. **21A,** by lithography and dry etching methods, the opening **43h** exposing the upper surface of the first lower electrode **42** is formed through the third insulating film **43.**

As shown in FIG. **21B,** the entire surface of the semiconductor substrate **31** is etched back to remove a portion of the first lower electrode **42** exposed at the bottom of the opening **43h.** Thereby, the first lower electrode **42** is formed with the recess **42h.** In this step, the first lower electrode **42** is preferably etched selectively. The reason for this is that thickness reduction of the third insulating film **43** which will contribute to a decrease in cell capacitance can be suppressed.

During the formation of the recess **42h,** the sides of the opening **43h** are formed with the second lower electrode **44** made of a material having been removed from the first lower electrode **42** during the formation of the recess **42h.** Specifically, during the formation of the recess **42h,** atoms emitted by hitting the portion of the first lower electrode **42** to be removed form, on the sides of the opening **43h,** the second lower electrode **44** of cylindrical, sidewall shape. Thus, the second lower electrode **44** can be formed only within the opening **43h** in a self-aligned manner. The opening **43h** and the recess **42h** constitute an opening defining the capacitance.

In FIG. **21B,** the recess **42h** has a depth capable of exposing the oxygen barrier film **41,** but the depth is not limited to this. For example, if the recess **42h** has a depth incapable of exposing the oxygen barrier film **41** or the oxygen barrier film **41** is made of a material equivalent to the material for the first lower electrode **42,** the oxygen barrier film **41** may be removed to such an extent that the upper surface of the second contact plug **40** is not exposed (that is, the second lower electrode **44** may be formed so that the removed oxygen barrier film **41** adheres onto the sides of the opening **43h** to mix with the material for the first lower electrode **42).**

In this structure, the second lower electrode **44** can be annealed in an oxygen atmosphere after the step of forming the second lower electrode **44** by an etch back. Annealing of the second lower electrode **44** in an oxygen atmosphere can strengthen the bonding power of the second lower electrode **44** that has been weakened once by the etch back. For example, if the second lower electrode **44** is made of a conductive oxide, the phenomenon arises in which the etch back eliminates some of oxygen forming the conductive oxide. However, by this annealing, the conductive oxide with some of oxygen eliminated is reoxidized or oxygen is added to that conductive oxide, so that the second lower electrode **44** can exert a sufficient function as an electrode.

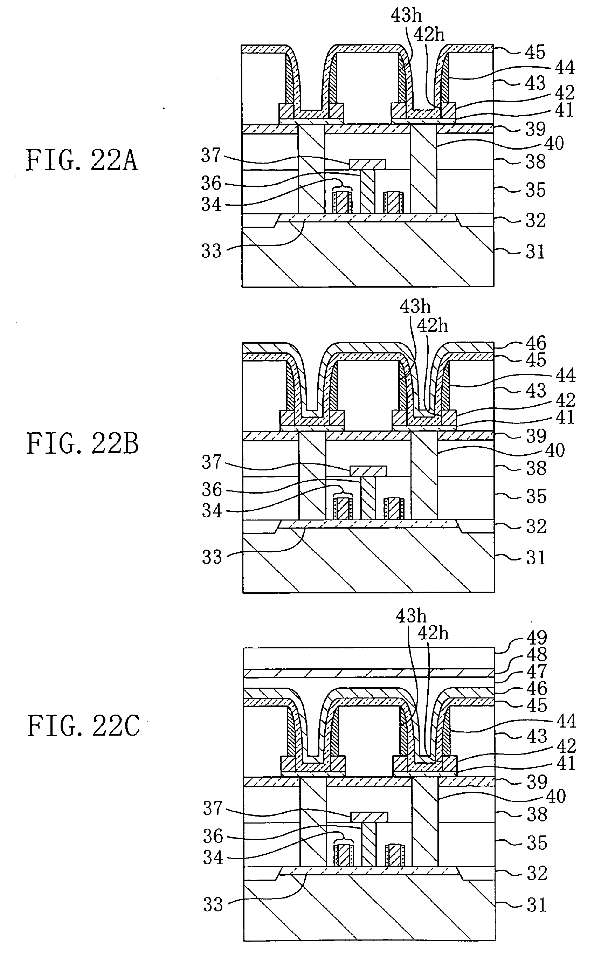

Subsequently to the formation of the second lower electrode **44,** as shown in FIG. **22A,** by an MOCVD method, the capacitor insulating film **45** of a ferroelectric film (for example, an SBT-, a PZT-, or a BLT-based material) is formed on the sides and bottom of the first lower electrode **42,** the inclined surface of the second lower electrode **44,** and the top of the third insulating film **43.** In this case, an opening for capacitor element formation composed of the opening **43h** and the recess **42h** is formed to have a greater mouth diameter than the conventional example. Specifically, in the conventional example, in consideration of a margin for mask alignment in patterning, the lower electrode is formed also on a portion of the insulating film lying outside the opening for capacitor element formation. On the other hand, in the sixth embodiment of the present invention, the second lower electrode **44** is formed only within the opening for capacitor element formation. Therefore, the mouth diameter of the opening is greater than that of the conventional example. With this shape, the material gas used for formation of the capacitor insulating film **45** can enter the opening easily, so that the capacitor insulating film **45** with good step coverage can be formed. Moreover, as described previously, since the second lower electrode **44** has a sidewall shape, the capacitor insulating film **45** formed on the second lower electrode **44** is formed with good step coverage.

Next, as shown in FIG. **22B,** the upper electrode **46** (for example, precious metal typified by Pt or Ir, or an oxide of this metal) is formed on the surface of the capacitor insulating film **45.** In the manner described above, a ferroelectric capacitor is formed which is composed of the first lower electrode **42,** the second lower electrode **44,** the capacitor insulating film **45,** and the upper electrode **46.**

Subsequently, as shown in FIG. **22C,** the fourth insulating film **47** is formed on the upper electrode **46** so that the opening **43h** is filled with the film, and then on the fourth insulating film **47,** the second hydrogen barrier film **48** and the fifth insulating film **49** are sequentially formed from bottom to top.

In the sixth embodiment, description has been made of the structure of the device in which the second hydrogen barrier film **48** is formed between the fourth insulating film **47** covering the capacitor and the fifth insulating film **49** serving as an interlayer insulating film with respect to an external wire (not shown). If a ferroelectric material resistant to reduction is employed for the capacitor insulating film **45,** it is also acceptable that the first and second hydrogen barrier films **39** and **48** are not formed. However, in general, a combination of the hydrogen barrier films, for example, connection of the first and second hydrogen barrier films **39** and **48** at an edge of the memory cell enables a full covering of the capacitor with the hydrogen barrier films, and thereby deterioration in the characteristics of the ferroelectric capacitor by hydrogen can be prevented.

As described above, with the dielectric memory device and its fabrication method according to the sixth embodiment of the present invention, the second lower electrode **44** is formed only within the opening (hole) **43h** for capacitor element formation in a self-aligned manner. Therefore, the electrode can be formed within the opening for capacitor element formation having a desired size suited for cell miniaturization. That is to say, with the dielectric memory device and its fabrication method according to the sixth embodiment of the present invention, miniaturization of the cell can be accomplished.

Moreover, with the dielectric memory device and its fabrication method according to the sixth embodiment of the present invention, the second lower electrode **44** is formed only within the opening (hole) **43h** for capacitor element formation in a self-aligned manner. This eliminates the necessity to perform patterning in forming the lower electrode, which would be required for the conventional example. As described previously, in the case of the conventional example, the lower electrode has to be formed to outwardly expand even onto the outside of the opening in consideration of a margin for mask alignment required for the patterning of the lower electrode. On the other hand, with the dielectric memory device and its fabrication method according to the sixth embodiment of the present invention, owing to the unnecessity of patterning, the cell of the device can be miniaturized by an area of a portion of the lower electrode of the conventional example which lies outside the opening.

Herein, a concrete description will be made of to what extent the margin for mask alignment necessary for the patterning of the lower electrode is required in the conventional example. The margin for mask alignment depends on: the alignment accuracy of stepper or scanning stepper equipment requiring the mask alignment; the accuracy of processing of the opening for capacitor element formation; and the accuracy of processing of the lower electrode. For example, assuming that variations in processing of the opening for capacitor element formation (a depth of 0.5 µm) are 10%, variations in processing of the lower electrode (> 0.5 µm) are 10%, and the mask alignment accuracy is 30 nm, a margin necessary for mask alignment is [0.03² + (0.50 × 0.10)² × 2]0.5^{0.5} = 0.0768 µm. Therefore, with the dielectric memory device and its fabrication method according to the sixth embodiment of the present invention, the area where the cell makes up can be reduced by, for example, a margin for mask alignment of 0.0768 µm which would be required in the conventional example.

Furthermore, with the dielectric memory device and its fabrication method according to the sixth embodiment of the present invention, there is no need to use a mask in forming the second lower electrode **44.** Therefore, the number of masks required can be decreased, which in turn reduces the number of fabrication steps such as elimination of a mask removal step. Consequently, the yield of the device can be improved.

With the dielectric memory device and its fabrication method according to the sixth embodiment of the present invention, reduction of the oxygen barrier film **41** formed below the first lower electrode **42** can be prevented. As for this point, in the conventional example, a photoresist having been used for the patterning has to be removed by ashing or the like after processing (patterning) of the lower electrode. Since photoresist contains a large number of C-H groups, C-H bondings in these groups are cut during the ashing to produce hydrogen. The produced hydrogen, however, reduces, for example, the underlying oxygen barrier film of a conductive oxide or the lower electrode if the lower electrode is made of a conductive oxide. This causes the trouble in which the oxygen barrier property decreases or in which excessive metal components produced by the reduction diffuse in the ferroelectric film to increase leakage current. However, with the dielectric memory device and its fabrication method thereof according to the sixth embodiment of the present invention, the second lower electrode **44** does not have to be patterned, which eliminates the necessity of photoresist ashing. Therefore, in forming the second lower electrode **44,** the problem of the occurrence of reduction of the oxygen barrier film **41** can be avoided.

Moreover, in conventional techniques, a hard mask may be used when the lower electrode is processed. However, the hard mask provided within the opening for capacitor element formation is formed to extend along the wall portion of the opening, so that after the processing of the lower electrode, it is difficult to remove the mask by a dry etching method that is an anisotropic etching. Even in the case of employing a wet etching method that is an isotropic etching, it is difficult for an adequate amount of chemical solution to enter the fine opening for capacitor element formation. Therefore, it is difficult to fully remove the hard mask. Because of the mask still remaining therewithin, the problem will arise in which the remaining mask has an adverse effect on a later step of forming the capacitor insulating film. However, with the dielectric memory device and its fabrication method thereof according to the sixth embodiment of the present invention, the second lower electrode **44** does not have to be patterned using the hard mask. Therefore, the problem mentioned above can be avoided.

Furthermore, the opening for capacitor element formation is concave in the conventional example. Therefore, in the step of etching the lower electrode covering the concave portion, the concave portion affects the thickness of the photoresist to be used in this etching, so that this thickness becomes ununiform to create a standing wave effect. This effect has an influence on the lithography to hinder a high-resolution patterning. However, with the dielectric memory device and its fabrication method thereof according to the sixth embodiment of the present invention, the second lower electrode **44** does not have to be patterned. Therefore, the problem mentioned above can be avoided.

Moreover, the opening for capacitor element formation is composed of the opening **43h** and the recess **42h.** Therefore, a capacitor element to be formed can secure a sufficient capacitance and there is no need to have concern about a decrease in step coverage at the lower portion of the opening for capacitor element formation.

The opening **43h** is preferably formed to have a taper angle of 80 to 90°. This is because if this taper angle is smaller than a range of 80 to 90°, it becomes difficult to perform etch back in a later step to form the second lower electrode 44 along the sides of the opening **43h.**

Finally, consideration will be given to the range of depth of the recess **42h.** First, the upper limit for the depth of the recess **42h** is restricted by the thickness of the first lower electrode **42.** Considering that a decrease in the area of the bottom electrode is prevented and that recoil of the oxygen barrier film **41** is prevented because recoil of the underlying material is employed as a formation method of the electrode, the upper limit is preferably set at the range that does not deviate from the thickness of the first lower electrode **42.** Therefore, the upper limit for the thickness is determined within the range in which the first lower electrode **42** does not collapse. If the shorter side of the first lower electrode **42** is 0.5 µm, this limit is estimated at an aspect ratio of about 1, that is, a thickness of about 500 nm.

### (Seventh Embodiment)

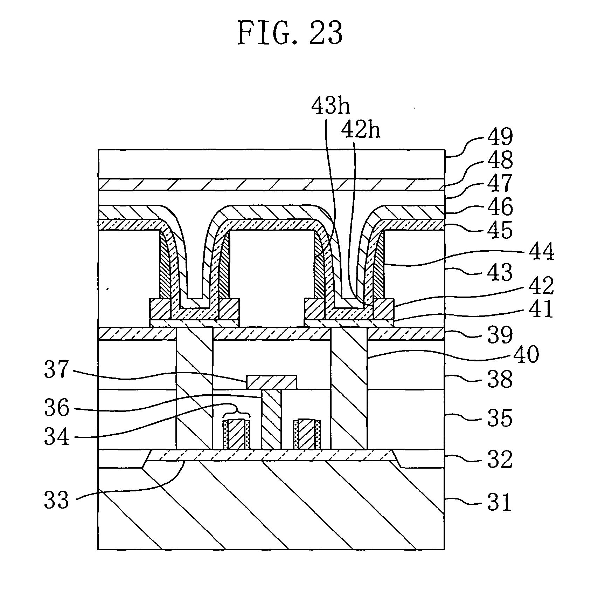

A dielectric memory device according to a seventh embodiment of the present invention will be described below with reference to FIG. **23.** FIG. **23** is a sectional view showing main parts of the structure of the dielectric memory device according to the seventh embodiment of the present invention. Hereinafter, the components of the dielectric memory device according to the seventh embodiment of the present invention that are the same as those of the dielectric memory device according to the sixth embodiment of the present invention retain the same reference numerals, so that detailed description thereof will be omitted.

The dielectric memory device according to the seventh embodiment of the present invention is characterized in that the second lower electrode **44** has a greater thickness than that of the sixth embodiment, and other characteristics thereof are the same as those of the dielectric memory device according to the sixth embodiment.

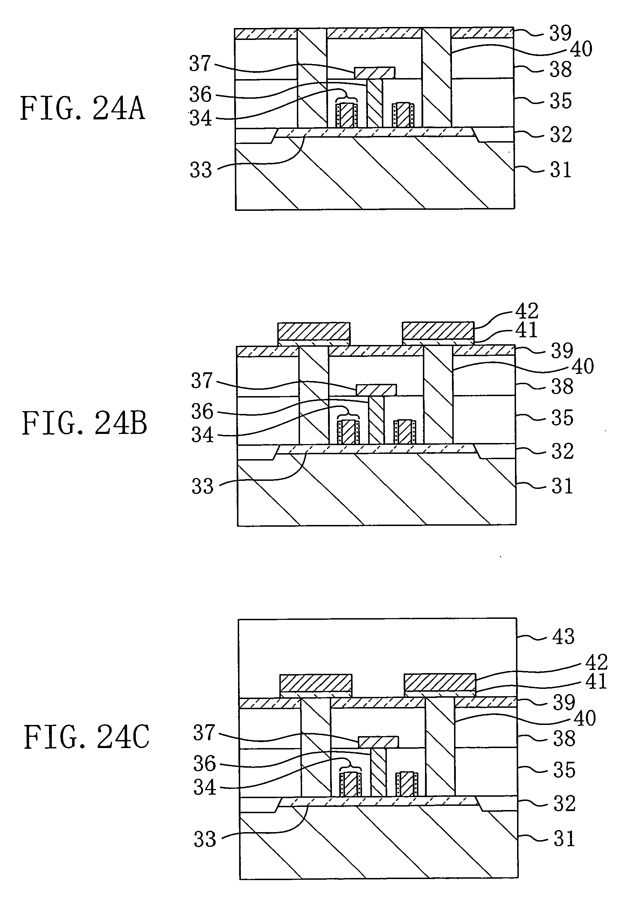

Hereinafter, a method for fabricating a dielectric memory device according to the seventh embodiment of the present invention will be described with reference to FIGS. **24A** to **24C, 25A** to **25C,** and **26A** to **26C.** FIGS. **24A** to **24C, 25A** to **25C,** and **26A** to 26C are sectional views showing main process steps of the method for fabricating a dielectric memory device according to the seventh embodiment of the present invention.

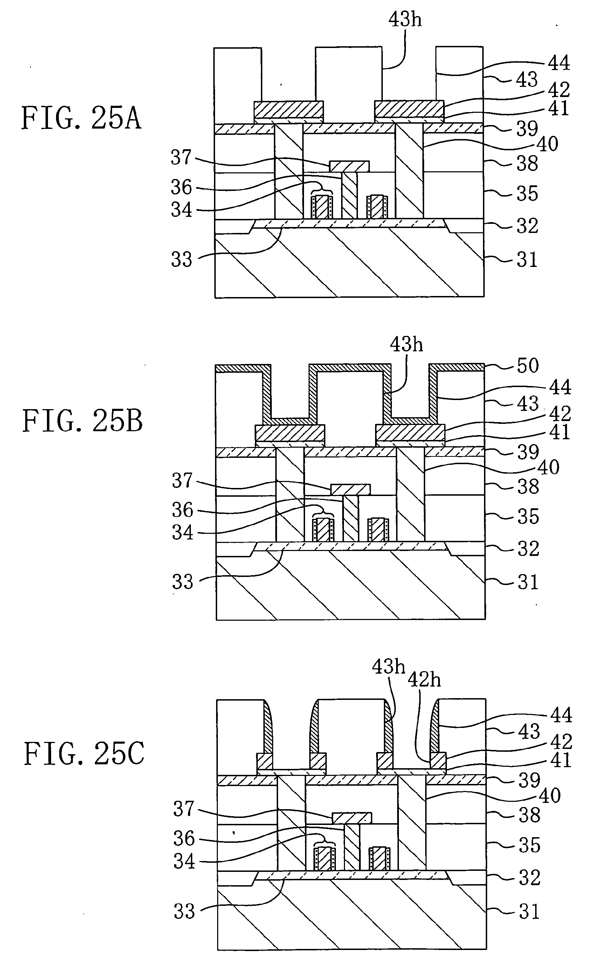

First, FIGS. **24A** to **24C** and **25A** show the same steps as those described using FIGS. **20A** to **20C** and **21A,** respectively.

Next, as shown in FIG. **25B,** a conductive film **50** is formed on sides and bottom of the opening **43h** and on top of the third insulating film **43.**

In this step, as described later, part of the conductive film **50** will be formed of part of the second lower electrode **44,** so that it is preferably made of the same material as the first lower electrode **42.** Considering that the first lower electrode **42** is formed with the recess **42h,** the conductive film **50** is preferably formed on the bottom of the opening **43h** as little as possible. Therefore, for formation of the conductive film **50,** it is preferable to employ a sputtering method that provides a poorer step coverage than CVD or plating methods.

Subsequently, as shown in FIG. **25C,** the entire surface of the semiconductor substrate **31** is etched back to remove a portion of the conductive film **50** lying on the bottom of the opening **43h** and a portion of the first lower electrode **42** located below that portion. Thereby, the first lower electrode **42** is formed with the recess **42h.** In this step, the upper portion of the third insulating film **43** is not etched until the conductive film **50** is etched to expose the third insulating film **43** lying under the conductive film 50. Therefore, thickness reduction of the third insulating film **43** which will contribute to a decrease in cell capacitance can be suppressed.

During the formation of the recess **42h,** the sides of the opening **43h** are formed with the second lower electrode **44** made of a material having been removed from the conductive film **50** and the first lower electrode **42** during the formation of the recess **42h.** Specifically, during the formation of the recess **42h,** atoms emitted by hitting the portions of the conductive film 50 and the first lower electrode **42** to be removed form, on the sides of the opening **43h,** the second lower electrode **44** of cylindrical, sidewall shape. Thus, the second lower electrode **44** can be formed only within the opening **43h** in a self-aligned manner. The second lower electrode **44** in the seventh embodiment is formed to have a greater thickness than the second lower electrode **44** in the sixth embodiment mentioned above. The opening **43h** and the recess **42h** constitute an opening defining the capacitance.

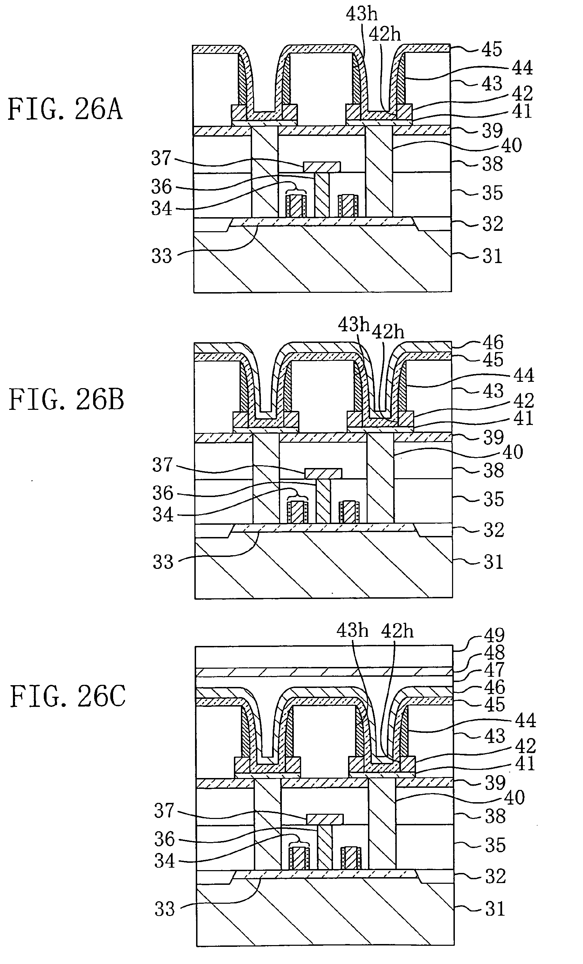

Next, FIGS. **26A** to **26C** show the same steps as those described using FIGS. **22A** to **22C,** respectively.

As described above, the method for fabricating a dielectric memory device according to the seventh embodiment of the present invention is characterized, as compared with the sixth embodiment, in that the conductive film **50** is formed before the recess **42h** is formed in the first lower electrode **42.** With this characteristic, in forming the recess **42h,** part of the first lower electrode **42** and part of the conductive film **50** are removed to form the second lower electrode **44,** so that the second lower electrode **44** of the dielectric memory device according to the seventh embodiment of the present invention has a greater thickness than that according to the sixth embodiment. Therefore, with the dielectric memory device and its fabrication method according to the seventh embodiment of the present invention, not only the effects of the sixth embodiment but also a further effect of increasing process stability can be exerted.

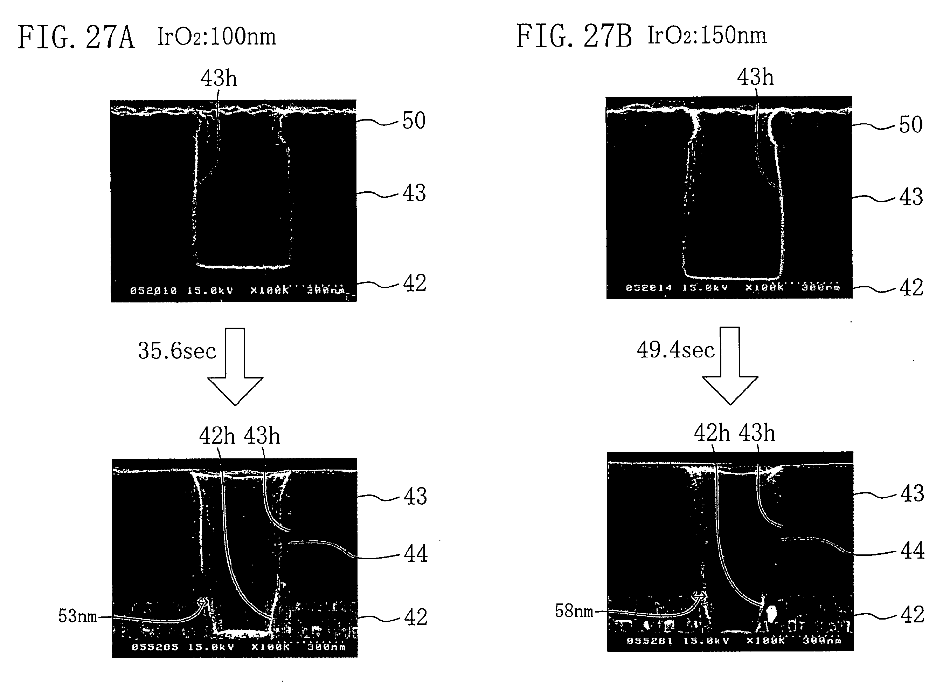

FIGS. **27A** and **27B** are sectional views for concretely explaining the step of forming the recess **42h** in the first lower electrode **42** by the method for fabricating a dielectric memory device according to the seventh embodiment of the present invention. FIG. **27A** shows the case where the first lower electrode **42** is made of IrO₂ and has a thickness of 100 nm. The upper view of FIG. 27A shows the state before formation of the recess **42h,** while the lower view of FIG. **27A** shows the state after formation of the recess **42h.** FIG. **27B** shows the case where the first lower electrode **42** is made of IrO₂ and has a thickness of 150 nm. The upper view of FIG. **27B** shows the state before formation of the recess **42h,** while the lower view of FIG. **27B** shows the state after formation of the recess **42h.**

First, it is found that before formation of the recess **42h** shown in the upper views of FIGS. **27A** and **27B,** the conductive film **50** is formed on top of the third insulating film **43** but it is hardly formed within the opening **43h** with a depth of about 600 nm. This is because a sputtering method is employed for formation of the conductive film **50.**

In such states, dry etching was performed on the condition of: 0.3 Pa of a pressure; 1500 W of an upper electrode power within an etching chamber; 600 W of a lower electrode power therewithin; 60 mL/min of a flow rate of Cl₂ gas as an etching gas; and 170 mL/min of a flow rate of Ar gas. In this case, the etching was performed using a method of detecting the end point of IrO₂ forming the first lower electrode **42.** As a result of this dry etching, it took 35.6 sec to perform the dry etching to form the structure shown in the upper view of FIG. **27A** into the structure shown in the lower view thereof, and it took 49.4 sec to form the structure shown in the upper view of FIG. **27B** into the structure shown in the lower view thereof.

Moreover, it is found that as shown in the lower views of FIGS. **27A** and **27B,** respectively, the first lower electrode **42** was formed with the recess **42h** and the sides of the opening **43h** were formed with the second lower electrode **44.**

In the case shown in the lower view of FIG. **27A**, the thickness of the bottom of the second lower electrode **44** was as great as 53 nm, which is a thickness enough to prevent a break in the electrode. Since each side of the second lower electrode **44** has a thickness decreasing upward of the opening **43h,** the opening for capacitor element formation composed of the opening **43h** and the recess **42h** has an upward-expanding shape (a sidewall shape). Therefore, the step coverage can be improved in a later step of forming the upper electrode **46** or the capacitor insulating film **45** of a ferroelectric film.

Also, in the case shown in the lower view of FIG. **27B,** the thickness of the bottom of the second lower electrode **44** was as great as 58 nm, which is a thickness enough to prevent a break in the electrode. Moreover, each side of the second lower electrode **44** has a thickness decreasing upward of the opening **43h.** Therefore, as in the case mentioned above, the step coverage can be improved in forming the upper electrode **46** or the capacitor insulating film **45** of a ferroelectric film.

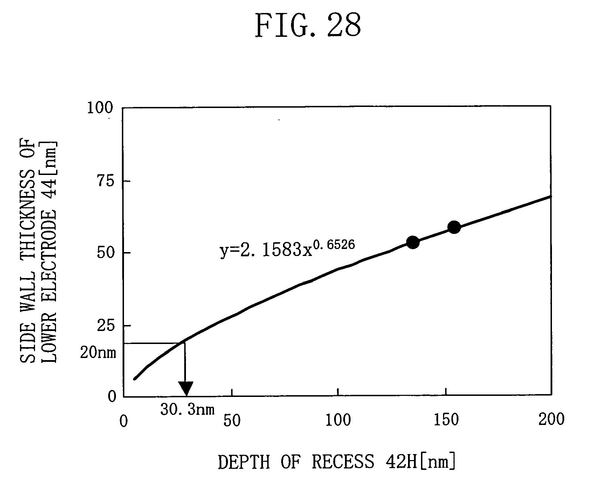

Based on the result shown in FIGS. **27A** and **27B** and the assumption that the second lower electrode **44** is hardly formed on the sides of the opening **43h** if recoil becomes zero (the state in which the recess **42h** is not formed), the exponential approximation curve of an expected relation between the depth of the recess **42h** and the thickness of each side of the second lower electrode **44** is shown in the graph of FIG. **28.**

Referring to FIG. **28,** it is found that for a thickness of 20 nm, which is the thickness of the electrode having achievements on polarization creation, the depth of the recess **42h** is about 30 nm. Therefore, the depth of the recess **42h** is preferably about 30 to 500 nm.

### (Eighth Embodiment)

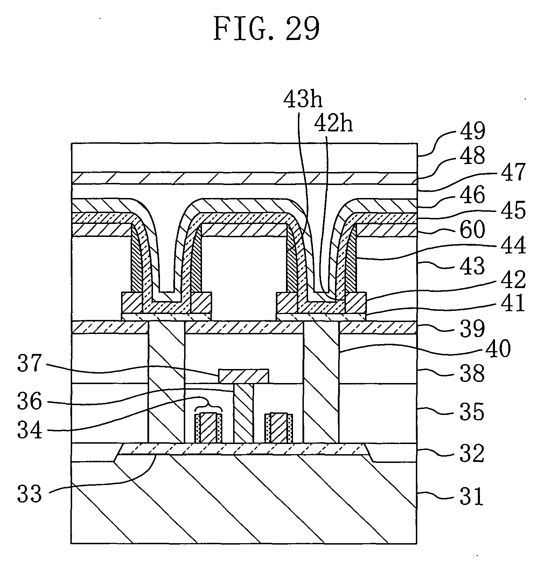

A dielectric memory device according to an eighth embodiment of the present invention will be described below with reference to FIG. **29.** FIG. **29** is a sectional view showing main parts of the structure of the dielectric memory device according to the eighth embodiment of the present invention. Hereinafter, the components of the dielectric memory device according to the eighth embodiment of the present invention that are the same as those of the dielectric memory device according to the six embodiment of the present invention retain the same reference numerals, so that detailed description thereof will be omitted.

Referring to FIG. **29,** the dielectric memory device according to the eighth embodiment of the present invention differs from the above-described dielectric memory device according to the sixth embodiment of the present invention in that an etch stop film **60** is formed on top of the third insulating film **43.** With this difference, the opening **43h** is formed to penetrate the etch stop film **60** and the third insulating film **43.**

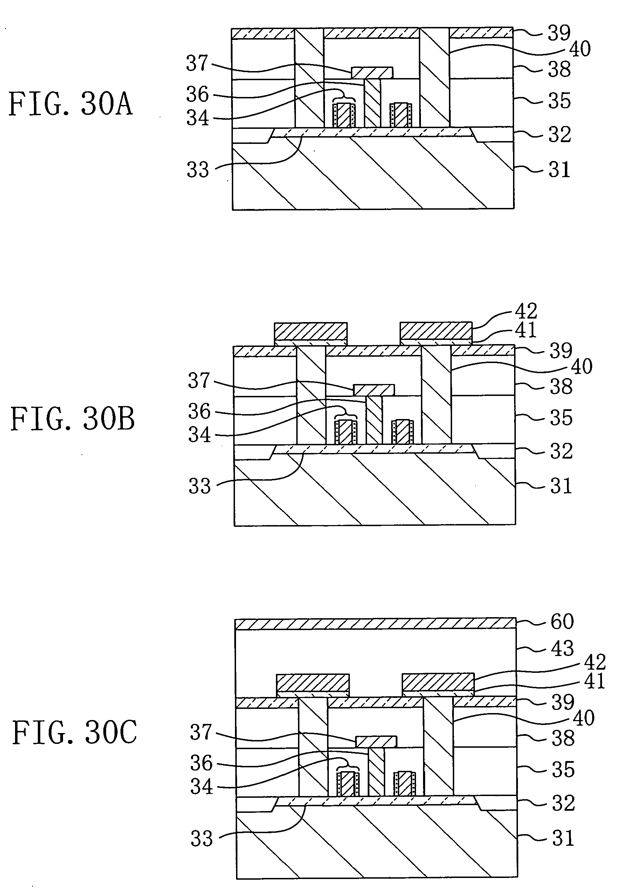

Hereinafter, a method for fabricating a dielectric memory device according to the eighth embodiment of the present invention will be described with reference to FIGS. **30A** to **30C, 31A** to **31C,** and **32A** and **32B.** FIGS. **30A** to **30C, 31A** to **31C,** and **32A** and **32B** are sectional views showing main process steps of the method for fabricating a dielectric memory device according to the eighth embodiment of the present invention.

First, FIGS. **30A** and **30B** show the same process steps as those described using FIGS. **20A** and **20B**, respectively.

Next, as shown in FIG. **30C,** over the first hydrogen barrier film **39,** the third insulating film **43** is formed to cover the oxygen barrier film **41** and the first lower electrode **42,** and then the surface of the third insulating film **43** is planarized by a CMP method or the like. In addition, the etch stop film **60** (for example, a SiN film or a SiON film with a thickness of about 20 to 100 nm) is formed on the third insulating film **43.** In this formation, a material more difficult to etch than the third insulating film **43** is preferably employed for the etch stop film **60.**

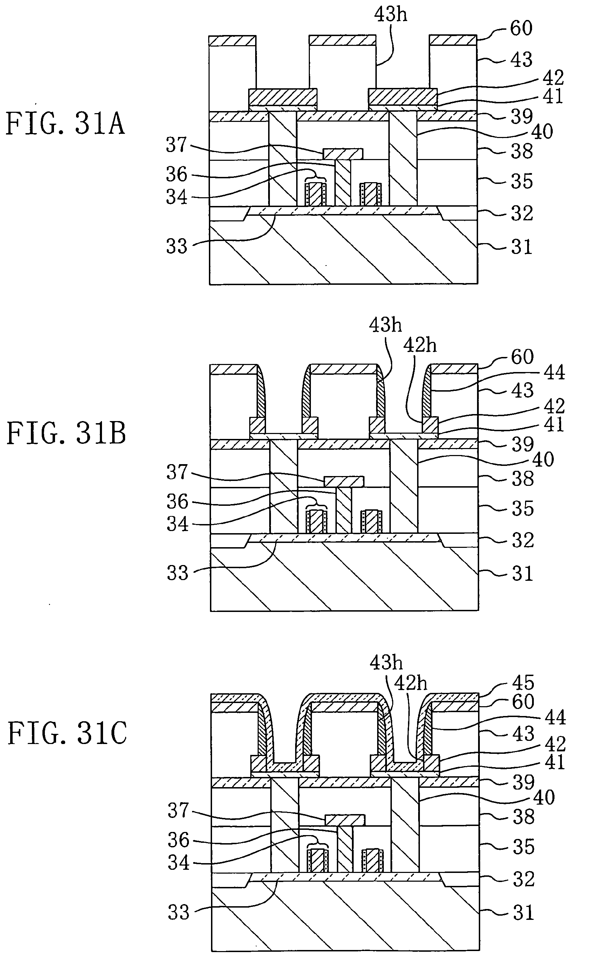

As shown in FIG. **31A,** through the third insulating film **43** and the etch stop film **60,** the opening (hole) **43h** is formed which penetrates the third insulating film **43** and the etch stop film **60** to expose the upper surface of the first lower electrode **42.** Like the sixth embodiment, the opening **43h** is preferably formed to have a taper angle of 80 to 90°. This is because if this taper angle is smaller than a range of 80 to 90°, it becomes difficult to perform etch back in a later step to form the second lower electrode **44** along the sides of the opening **43h.**

Subsequently, as shown in FIG. **31B,** the entire surface of the semiconductor substrate **31** is etched back to remove a portion of the first lower electrode **42** exposed at the bottom of the opening **43h.** Thereby, the first lower electrode **42** is formed with the recess **42h.** In this step, since the material difficult to etch is used for the etch stop film **60,** thickness reduction of the third insulating film **43** which will contribute to a decrease in cell capacitance can be suppressed.

During the formation of the recess **42h,** the sides of the opening **43h** are formed with the second lower electrode **44** made of a material having been removed from the first lower electrode **42** during the formation of the recess **42h.** Specifically, during the formation of the recess **42h,** atoms emitted by hitting the portion of the first lower electrode **42** to be removed form, on the sides of the opening **43h,** the second lower electrode **44** of cylindrical, sidewall shape. Thus, the second lower electrode **44** can be formed only within the opening **43h** in a self-aligned manner. The opening **43h** and the recess **42h** constitute an opening defining the capacitance.

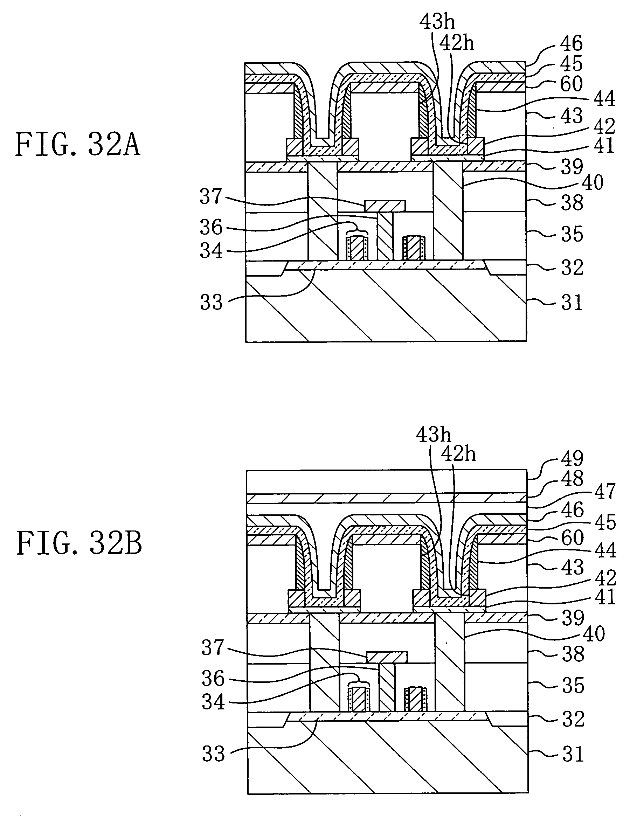

Next, FIGS. **31C, 32A,** and **32B** show process steps similar to those described using FIGS. **22A** to **22C,** respectively.

As described above, the dielectric memory device and its fabrication method according to the eighth embodiment of the present invention can exert the same effects as the sixth embodiment. In addition to this, they are characterized, as compared with the sixth embodiment, in that as shown in FIG. **30C,** the etch stop film **60** is formed on top of the third insulating film **43** before formation of the opening **43h** through the third insulating film **43.** With this characteristic, in the dielectric memory device and its fabrication method according to the eighth embodiment of the present invention, in the step of performing etch back to form the recess **42h,** the third insulating film **43** is more difficult to etch than the sixth embodiment. Therefore, thickness reduction of the third insulating film **43** which will contribute to a decrease in cell capacitance can be suppressed.

### (Ninth Embodiment)

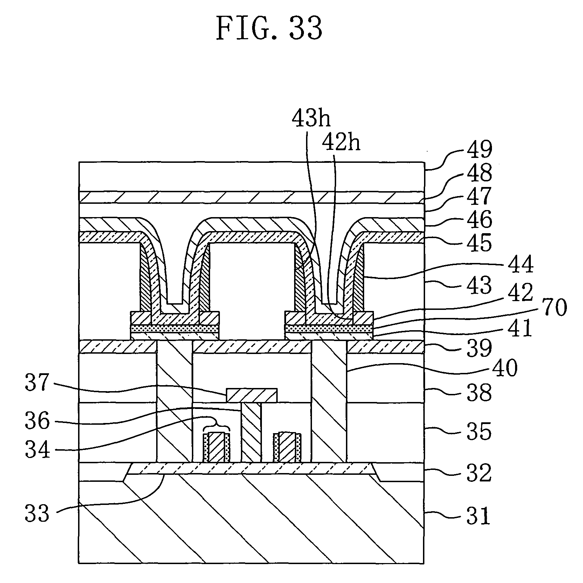

A dielectric memory device according to a ninth embodiment of the present invention will be described below with reference to FIG. **33.** FIG. **33** is a sectional view showing main parts of the structure of the dielectric memory device according to the ninth embodiment of the present invention. Hereinafter, the components of the dielectric memory device according to the ninth embodiment of the present invention that are the same as those of the dielectric memory device according to the six embodiment of the present invention retain the same reference numerals, so that detailed description thereof will be omitted.

Referring to FIG. **33,** the dielectric memory device according to the ninth embodiment of the present invention differs from the above-described dielectric memory device according to the sixth embodiment of the present invention in that a conductive layer **70** is formed between the oxygen barrier film **41** and the first lower electrode **42.**

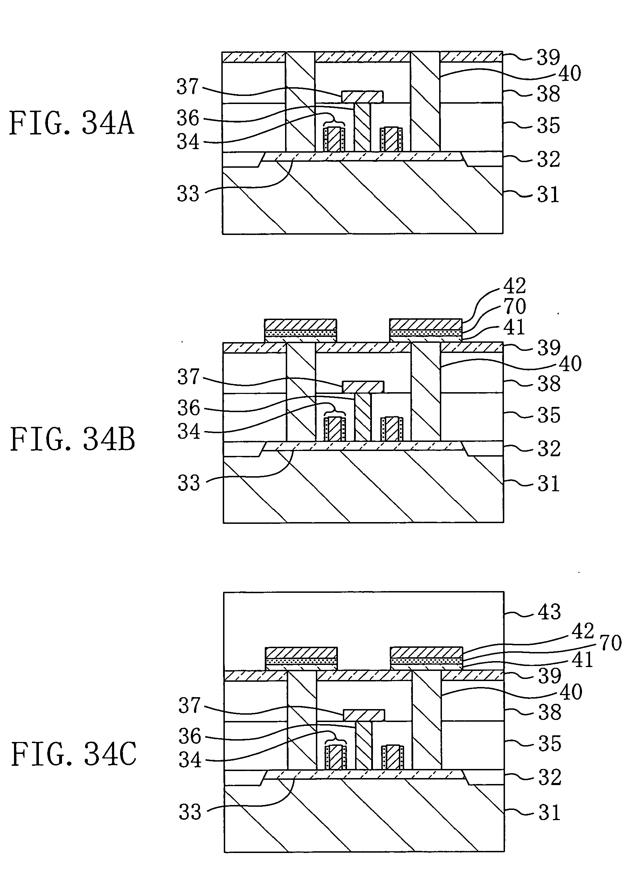

Hereinafter, a method for fabricating a dielectric memory device according to the ninth embodiment of the present invention will be described with reference to FIGS. **34A** to **34C, 35A** to **35C,** and **36A** and **36B**. FIGS. **34A** to **34C, 35A** to **35C,** and **36A** and **36B** are sectional views showing main process steps of the method for fabricating a dielectric memory device according to the ninth embodiment of the present invention.

First, FIG. **34A** shows the same process step as that described using FIG. **20A.**

Next, as shown in FIG. **34B,** on the first hydrogen barrier film **39,** the oxygen barrier **film** 41 exhibiting conductivity (for example, having a thickness of 20 to 200 nm and made of a film of Ir, IrO₂, TiAIN, and TaAIN or a stacked film of these materials) is formed to cover the second contact plug **40** to connect the lower surface to the upper end of the second contact plug **40.** The conductive layer **70** is then formed on the formed oxygen barrier film **41.** The first lower electrode **42** (for example, having a thickness of 100 to 500 nm and made of precious metal typified by Pt or Ir, or an oxide of this metal) is formed on the conductive layer **70.**

In this structure, like the description of the sixth embodiment, the depth of the opening **43h** that will be formed later can be adjusted in accordance with the thickness of the first lower electrode **42.** Therefore, it is recommended that the thickness of the first lower electrode **42** is determined in consideration of a necessary cell capacitance.

Subsequently, as shown in FIG. **34C,** over the first hydrogen barrier film **39,** the third insulating film **43** (for example, a SiO₂ film with a thickness of 500 to 1000 nm) is formed to cover the oxygen barrier film **41,** the conductive layer **70,** and the first lower electrode **42.** Then, the surface of the first insulating film **43** is planarized by a CMP method.

In this step, like the description of the sixth embodiment, the depth of the opening **43h** that will be formed later can be adjusted in accordance with the thickness of the third insulating film **43** remaining after the planarization by a CMP method. Therefore, it is recommended that, as in the case of the thickness of the first lower electrode **42,** the thickness of the remaining third insulating film **43** is determined in consideration of a necessary cell capacitance.

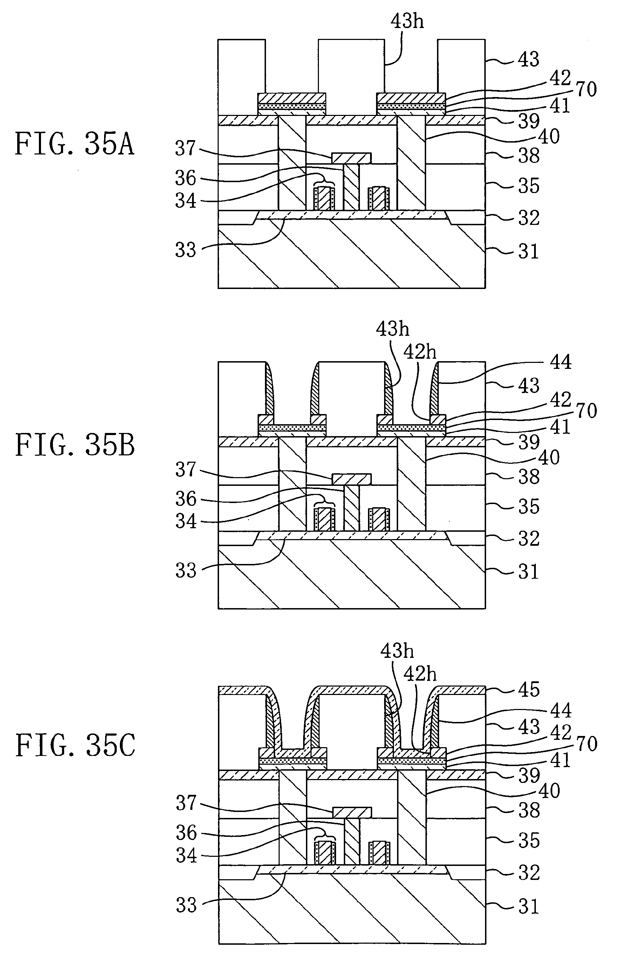

Subsequently, as shown in FIG. **35A,** through the third insulating film **43,** the opening **43h** is formed which is a hole penetrating the third insulating film **43** to expose the upper surface of the first lower electrode **42.**

As shown in FIG. **35B,** the entire surface of the semiconductor substrate **31** is etched back to remove a portion of the first lower electrode **42** exposed at the bottom of the opening **43h.** Thereby, the first lower electrode **42** is formed with the recess **42h** exposing the upper surface of the conductive layer **70.** In this embodiment, an etching condition or a material for the conductive layer **70** which can prevent the conductive layer **70** from being etched by the etching of the first lower electrode **42** can be selected to form the recesses **42h** having uniform depths within the plane of the conductive layer **70** exposing the surface thereof. This suppresses variations in cell capacitance. That is to say, by providing the first lower electrode **42** with a desired thickness and letting the conductive layer **70** function as an etch stop film, the depth of the recess **42h** can be adjusted to a desired value.

During the formation of the recess **42h,** the sides of the opening **43h** are formed with the second lower electrode **44** made of a material having been removed from the first lower electrode **42** during the formation of the recess **42h.** Specifically, during the formation of the recess **42h,** atoms emitted by hitting the portion of the first lower electrode **42** to be removed form, on the sides of the opening **43h,** the second lower electrode **44** of cylindrical, sidewall shape. Thus, the second lower electrode **44** can be formed only within the opening **43h** in a self-aligned manner. The opening **43h** and the recess **42h** constitute an opening defining the capacitance.

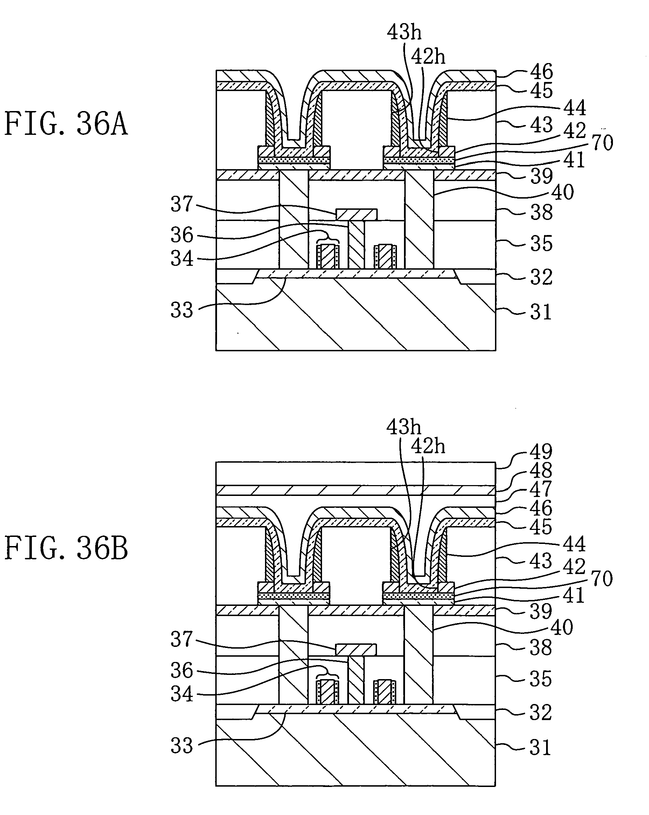

Next, FIGS. **35C, 36A,** and **36B** show process steps similar to those described using FIGS. **22A** to **22C,** respectively.

As described above, the dielectric memory device and its fabrication method according to the ninth embodiment of the present invention are characterized in that the conductive layer **70** is provided between the oxygen barrier film **41** and the first lower electrode **42.** With this characteristic, the conductive layer **70** functions as an etch stop film in forming the recess **42h** in the first lower electrode **42,** so that the depth of the recess **42h** can be adjusted to suppress variations in cell capacitance.

In the sixth to ninth embodiments shown above, description has been made of the case where the recess **42h** is formed by removing a portion of the first lower electrode **42** (in the seventh embodiment, the conductive film **50** and the first lower electrode **42)** located at the bottom of the opening **43h.** However, depending on the material for the oxygen barrier film **41** (in the ninth embodiment, the conductive layer **70** and the oxygen barrier film **41)** formed below the first lower electrode **42,** the oxygen barrier film **41** may be removed together to form the recess **42h.**

In the sixth to ninth embodiments shown above, the structures fabricated in the manner described below can also be employed. To be more specific, to the seventh embodiment, at least one of the step of forming the etch stop film **60** that is one characteristic of the eighth embodiment and the step of forming the conductive layer **70** that is one characteristic of the ninth embodiment may be added. To the eighth embodiment, at least one of the step of forming the conductive film **50** that is one characteristic of the seventh embodiment and the step of forming the conductive layer **70** that is one characteristic of the ninth embodiment may be added. To the ninth embodiment, at least one of the step of forming the conductive film **50** that is one characteristic of the seventh embodiment and the step of forming the etch stop film **60** that is one characteristic of the eighth embodiment may be added.

In the sixth to ninth embodiments shown above, description has been made of the structure in which the second hydrogen barrier film is formed between the fourth insulating film covering the capacitor and the fifth insulating film serving as an interlayer insulating film with respect to an external wire (not shown). If a ferroelectric material resistant to reduction is employed for the capacitor insulating film, it is also acceptable that the first and second hydrogen barrier films are not formed. However, in general, a combination of the hydrogen barrier films, for example, connection of the first and second hydrogen barrier films at an edge of the memory cell enables a full covering of the capacitor with the hydrogen barrier films, and thereby deterioration in the characteristics of the ferroelectric capacitor by hydrogen can be prevented.

The dielectric memory device and its fabrication method according to the present invention are useful for formation of a dielectric memory device with a 3D-stacked capacitor structure.

## Claims

1. A method for fabricating a dielectric memory device, comprising the steps of:
forming a first lower electrode above a substrate;
forming a first insulating film on the first lower electrode;
forming a hole through the first insulating film down to an upper surface of the first lower electrode;
forming a conductive film on at least the sides and bottom of the hole;
performing etching to remove a portion of the conductive film located on the bottom of the hole, thereby forming a second lower electrode made of the conductive film remaining on the sides of the hole;
forming a capacitor insulating film on the first and second lower electrodes so that the hole is not fully filled with the film; and
forming an upper electrode on the capacitor insulating film.

2. The method of claim 1, further comprising, after the step of forming a first insulating film and before the step of forming a hole, the step of forming, on the first insulating film, a second insulating film functioning as an etching stopper,
wherein the step of forming a hole is the step of forming a hole through the first and second insulating films down to an upper surface of the first lower electrode.

3. The method of claim 1, further comprising, after the step of forming a second lower electrode and before the step of forming a capacitor insulating film, the step of removing a portion of the first insulating film located above an upper edge of the second lower electrode.

4. The method of claim 1, further comprising, after the step of forming a second lower electrode and before the step of forming a capacitor insulating film, the step of annealing the second lower electrode in an oxygen atmosphere.

5. The method of claim 1,
wherein the step of forming a capacitor insulating film is carried out using an MOCVD method.

6. The method of claim 1,
wherein the step of forming a conductive film is carried out using a sputtering method.

7. The method of claim 1,
wherein the first and second lower electrodes are made of the same conductive material.

8. The method of claim 1,
wherein the first and second lower electrodes are made of different conductive materials.

9. A method for fabricating a dielectric memory device, comprising the steps of:
forming a first lower electrode above a substrate;
forming a first insulating film on the first lower electrode;
forming a hole through the first insulating film down to an upper surface of the first lower electrode;
performing etching to remove a portion of the first lower electrode exposed at the bottom of the hole, thereby forming a recess in the first lower electrode and a second lower electrode on the sides of the hole, the second lower electrode being made of a material having formed the portion of the first lower electrode removed during formation of the recess;
forming a capacitor insulating film on the sides and bottom of the recess and on the second lower electrode so that the hole is not fully filled with the film; and
forming an upper electrode on the capacitor insulating film.

10. The method of claim 9, further comprising, after the step of forming a hole and before the step of forming a recess and a second lower electrode, the step of forming a conductive film on the sides and bottom of the hole,
wherein the step of forming a recess and a second lower electrode is the step of performing etching to remove portions of the first lower electrode and the conductive film formed on the bottom of the hole, thereby forming a recess in the first lower electrode and a second lower electrode on the sides of the hole, the second lower electrode being made of materials having formed the portions of the first lower electrode and the conductive film removed during formation of the recess.

11. The method of claim 9, further comprising, after the step of forming a first insulating film and before the step of forming a hole, the step of forming, on the first insulating film, a second insulating film functioning as an etching stopper,
wherein the step of forming a hole is the step of forming a hole through the first and second insulating films down to an upper surface of the first lower electrode.

12. The method of claim 9,
wherein the first lower electrode is formed on a conductive layer formed above the substrate, and
the etching is performed to remove a portion of the first lower electrode located on the bottom of the hole until the upper surface of the conductive layer is exposed.

13. The method of claim 9, further comprising, after the step of forming a second lower electrode and before the step of forming a capacitor insulating film, the step of annealing the second lower electrode in an oxygen atmosphere.

14. The method of claim 9,
wherein the step of forming a capacitor insulating film is carried out using an MOCVD method.

15. The method of claim 9,
wherein the first and second lower electrodes are made of precious metal or an oxide of precious metal.

16. A dielectric memory device comprising:
a first lower electrode formed above a substrate;
a first insulating film formed on the first lower electrode and having a hole reaching an upper surface of the first lower electrode;
a second lower electrode formed on the sides of the hole;
a capacitor insulating film formed on the first and second lower electrodes so that the hole is not fully filled with the film; and
an upper electrode formed on the capacitor insulating film,
wherein in the second lower electrode on the sides of the hole, a lower portion thereof on the lower part of the hole sides has a greater thickness than an upper portion thereof on the upper part of the hole sides.

17. The device of claim 16, further comprising, on top of the first insulating film, a second insulating film functioning as an etching stopper.

18. The device of claim 16,
wherein the first and second lower electrodes are made of the same conductive material.

19. The device of claim 16,
wherein the first and second lower electrodes are made of different conductive materials.

20. The device of claim 16,
wherein the first and second lower electrodes are made of precious metal or an oxide of precious metal.

21. A dielectric memory device comprising:
a first lower electrode formed above a substrate and having a recess in an upper portion thereof;
a first insulating film formed on the first lower electrode and having a hole reaching the recess;
a second lower electrode formed on the sides of the hole and having sidewalls continuous with the sides of the recess;
a capacitor insulating film formed on the sides and bottom of the recess and on the second lower electrode so that the hole is not fully filled with the film; and
an upper electrode formed on the capacitor insulating film,
wherein in the second lower electrode on the sides of the hole, a lower portion thereof on the lower part of the hole sides has a greater thickness than an upper portion thereof on the upper part of the hole sides.

22. The device of claim 21, further comprising, on top of the first insulating film, a second insulating film functioning as an etching stopper.

23. The device of claim 21,
wherein the first and second lower electrodes are made of the same conductive material.

24. The device of claim 21,
wherein the first and second lower electrodes are made of different conductive materials.

25. The device of claim 21,
wherein the first and second lower electrodes are made of precious metal or an oxide of precious metal.
